# EUROPÄISCHE PATENTANMELDUNG

(11) **EP 4 152 394 A1**
(43) Veröffentlichungstag der Anmeldung: **22.03.2023**
(21) Anmeldenummer: 21197599.0
(22) Anmeldetag: 20.09.2021
(51) Int. Cl.: H01L 27/11556, H01L 21/3063, H01L 27/11582

(54) **VERFAHREN ZUM ERZEUGEN VON VERTIKALEN KANALSTRUKTUREN IN DREIDIMENSIONAL INTEGRIERTEN HALBLEITERSPEICHERN**

(71) Anmelder: Fraunhofer-Gesellschaft zur Förderung der angewandten Forschung e.V., 80686 München (DE)
(72) Erfinder: Kutter, Christoph, 80686 München (DE)
(74) Vertreter: Hersina, Günter

(57) **Zusammenfassung**

Die vorliegende Erfindung betrifft einen bestimmten Verfahrensschritt ("Channel Hole Etching") bei der Erzeugung eines dreidimensional integrierten Halbleiterspeichers. Erfindungsgemäß zeichnet sich dieser Verfahrensschritt dadurch aus, dass die damit zu erzeugende vertikale Kanalstruktur (112), das sogenannte "Channel Hole", unter Anwendung eines anodischen Ätzverfahrens erzeugt wird. Dadurch können Schichtstapel (100) mit deutlich mehr Einzelschichten (101, 102) als im Stand der Technik prozessiert werden. Dementsprechend kann die Anzahl der Einzelschichten (101, 102) innerhalb eines zu prozessierenden Schichtstapels (100) erhöht werden, wodurch auch die Speicherkapazität des Schichtstapels (100) deutlich erhöht werden kann.

## Beschreibung

Das hierin beschriebene innovative Konzept betrifft einen bestimmten Verfahrensschritt zum Erzeugen von vertikalen Kanalstrukturen während eines Verfahrens zum Erzeugen eines dreidimensional integrierten Halbleiterspeichers. Diese vertikalen Kanalstrukturen werden in diesem Zusammenhang auch als Vertical Channel Holes bezeichnet. Das entsprechende Verfahren wird im Kontext von 3D-Halbleiterspeichern auch als Vertical Channel Hole Etching bezeichnet. Das hierin beschriebene innovative Konzept beschreibt ein neuartiges Verfahren, um vertikale Kanalstrukturen mit einer hohen Anisotropie zu erzeugen, sodass die Anzahl der Schichten in einem vertikalen Halbleiterspeicher, und somit dessen Speicherkapazität, signifikant erhöht werden kann.

Die vorliegende Erfindung liegt auf dem technischen Gebiet der Herstellung von dreidimensional integrierten Halbleiterspeichern, wie z.B. dreidimensionalen NAND Flash Speichern. Bei der dreidimensionalen Integration werden, im Vergleich zur herkömmlichen Planartechnik (x-y-Richtung), Bauelemente zusätzlich in vertikaler Richtung (z-Richtung) erstellt.

Sogenannte Flash-Speicherelemente werden beispielsweise mit NAND-Zellen realisiert. Um eine hohe Speicherkapazität von Flash-Speichern zu erzielen, werden die dafür benötigten NAND-Zellen vertikal übereinander angeordnet, was auch als dreidimensionale Systemintegration bezeichnet wird. Ein derartiger dreidimensionaler Speicherbaustein mit mehreren vertikal übereinander angeordneten Speicherzellen wird auch als 3D NAND bezeichnet.

In bisherigen Herstellungsverfahren zum Herstellen von 3D NAND Speichern werden viele einzelne Schichten von Si₃N₄-SiO₂ (Siliziumnitrid - Silizium(di-)oxid) aufeinander gestapelt, sodass ein vertikaler Schichtstapel entsteht. Mittels vertikal geätzten Löchern innerhalb des Schichtstapels werden die einzelnen Schichten des Schichtstapels dann lateral freigelegt, um anschließend die Si₃N₄-Schichten selektiv zu den SiO₂-Schichten ätzen zu können.

Dies ist einer der Kernprozesse bei der Herstellung von vertikalen Speicherzellstrukturen, der auch unter dem Begriff des sogenannten "Hole Channel Etchings" bekannt ist. Die dabei erzeugten, eingangs erwähnten, vertikal geätzten Löcher können aufgrund ihrer geometrischen Form auch als Kanalstrukturen bezeichnet werden. In diesen geätzten Kanalstrukturen, die im Rahmen des "Hole Channel Etchings" übrigens auch als "Hole Channels" bezeichnet werden können, wird in darauffolgenden Prozessen die Flash-Speicherzelle aufgebaut. Um möglichst hohe Speicherdichten bzw. Speicherkapazitäten zu erzielen, werden heute bis zu 100 alternierende Ebenen von SiO₂ und Si₃N₄ abgeschieden, sodass sich dementsprechend ein vertikaler Schichtstapel mit bis zu 100 abwechselnden SiO₂ - und Si₃N₄-Schichten ausbildet, der dann wiederum die vertikale Speicherzellstruktur bildet. Dieser vertikale Schichtstapel (Größenordnung 6-10 µm) wird, wie eingangs erwähnt, mit dem Verfahren des "Hole Channel Etchings" (Größenordnung Lochdurchmesser etwa 100 nm, Größenordnung Abstand der Löcher etwa 25 nm) bearbeitet.

Um also die Speicherkapazität eines derartigen vertikalen Schichtstapels zu erhöhen, muss die Anzahl der übereinander gestapelten Einzelschichten erhöht werden. Mit steigender Anzahl der Einzelschichten wächst natürlich auch die Höhe des vertikalen Schichtstapels, und dementsprechend müssen natürlich auch die vertikalen Kanalstrukturen immer tiefer ausgeführt werden, d.h. das Aspektverhältnis (Tiefe zu Breite) der vertikalen Kanalstrukturen muss erhöht werden.

Wie bereits zu Beginn erwähnt, dient das Vorsehen der vertikalen Kanalstrukturen unter anderem dazu, um einen Zugang zu den übereinander gestapelten Einzelschichten zu schaffen und über diesen Zugang die Si₃N₄-Schichten selektiv zu den SiO₂-Schichten zu ätzen. Aufgrund der soeben erwähnten Erhöhung des Aspektverhältnisses der vertikalen Kanalstrukturen wird es allerdings zunehmend schwieriger, mit den bisher bekannten Verfahren ein Kanalloch (channel hole) mit gleichbleibendem Durchmesser zu erzeugen. In der Realität ist die Ätzrate nicht perfekt gerichtet (senkrecht zum Schichtstapel), sondern hat eine laterale Komponente, sodass am Ende ein Channel Hole entsteht, das oben einen größeren Durchmesser hat als unten. Somit bildet sich innerhalb der vertikalen Kanalstruktur eine etwa trichterförmige Einschnürung aus, die sich nach unten hin verjüngt.

Aus diesem Grund können die vertikalen Kanalstrukturen nicht beliebig tief ausgeführt werden, da es ansonsten zu immer deutlicher ausgeprägten Abweichungen vom idealen Channel aufgrund des extrem hohen Aspektverhältnisses kommt. Heutzutage können etwa bis zu 100 Einzelschichten mit dieser Technik (sog. "high aspect ratio channel etch") geätzt werden. Somit ist die Anzahl von Einzelschichten innerhalb eines vertikalen Schichtstapels auf ebendiese etwa 100 Einzelschichten begrenzt. Dies bedeutet jedoch auch, dass der vertikale Schichtstapel nicht wesentlich mehr Einzelschichten aufweisen darf, was jedoch wiederum die Speicherkapazität des vertikalen Schichtstapels dementsprechend begrenzt. Das daraus resultierende Problem ist eine Limitierung in der Anzahl der Einzelschichten innerhalb des vertikalen Schichtstapels und somit eine dementsprechende Limitierung der Speicherkapazität.

Daher wäre es wünschenswert, bisherige Verfahren zum Herstellen von dreidimensional integrierten Halbleiterspeichern dahingehend zu verbessern, dass die Ätzratenhomogenität beim Erzeugen der vertikalen Kanalstrukturen (Channel Holes) gesteigert wird, wodurch die Anzahl der Einzelschichten innerhalb eines Schichtstapels erhöht werden kann, um die Speicherkapazität des Halbleiterspeichers dementsprechend zu vergrößern.

Dieses Ziel wird erreicht durch ein Verfahren gemäß Anspruch 1. Weitere Ausführungsformen und vorteilhafte Aspekte dieses Verfahrens sind in den jeweils abhängigen Patentansprüchen genannt.

Das erfindungsgemäße Verfahren dient im Wesentlichen zum Erzeugen von vertikalen Kanalstrukturen ("Channel Holes") in einem vertikalen Schichtstapel bei der Herstellung von dreidimensional integrierten Halbleiterspeichern. Hierbei wird zunächst ein Substrat bereitgestellt. Auf dem Substrat wird ein vertikaler Schichtstapel mit mehreren übereinander geschichteten Einzelschichten erzeugt, indem abwechselnd mehrere Einzelschichten eines ersten Materials sowie mehrere Einzelschichten eines unterschiedlichen zweiten Materials übereinander aufgetragen werden. Das erste Material und das zweite Material sind jeweils elektrisch leitend oder halbleitend. In dem Schichtstapel wird mindestens eine vertikale Kanalstruktur erzeugt, wobei sich die vertikale Kanalstruktur in vertikaler Richtung zumindest abschnittsweise durch den Schichtstapel hindurch erstreckt, sodass ein oder mehrere der Einzelschichten innerhalb der vertikalen Kanalstruktur freigelegt und durch die vertikale Kanalstruktur zugänglich gemacht werden. Das erfindungsgemäße Verfahren zeichnet sich insbesondere dadurch aus, dass das Strukturieren der vertikalen Kanalstruktur in dem Schichtstapel unter Anwendung eines anodischen Ätzverfahrens erfolgt. Hierbei wird ein erstes elektrisches Spannungspotential an einem ersten Abschnitt des Schichtstapels angelegt, und ein unterschiedliches zweites elektrisches Spannungspotential wird an einem unterschiedlichen zweiten Abschnitt des Schichtstapels angelegt. Zwischen dem ersten und dem zweiten Abschnitt fließt somit ein elektrischer Strom vertikal durch den Schichtstapel hindurch, der durch gerichtetes anodisches Ätzen die vertikale Kanalstruktur in dem Schichtstapel erzeugt.

Bei den eingangs diskutierten bekannten vertikalen Halbleiterspeichern aus dem Stand der Technik werden vertikale Schichtstapel aus abwechselnd aufeinanderfolgenden Si₃N₄-Schichten und SiO₂-Schichten erzeugt. Um diese Schichten zu ätzen, werden anisotrope Ätzverfahren, wie zum Beispiel gerichtetes Ionenstrahltiefenätzen, verwendet. Die mittels dieser anisotropen Ätzverfahren zu erzeugenden Aspektverhältnisses der vertikalen Kanalstrukturen sind jedoch begrenzt, sodass die Anzahl der einzelnen Schichten ebenfalls limitiert ist.

Das erfindungsgemäße Verfahren schlägt jedoch vor, anstelle der bisher verwendeten anisotropen Ätzverfahren, ein gerichtetes anodisches Ätzverfahren für das sogenannte "Channel Hole Etching" im Rahmen der Herstellung von dreidimensional integrierten Halbleiterspeichern anzuwenden. Das gerichtete anodische Ätzen hat im Vergleich zu den bisher verwendeten Ätztechniken (z.B. Ionenstrahltiefenätzen) eine deutlich höhere Ätzratenhomogenität, d.h. die vertikalen Kanalstrukturen können mit einem deutlich größeren Aspektverhältnis erzeugt werden, wodurch deutlich tiefere Kanalstrukturen innerhalb des Schichtstapels erzeugt werden können. Beim anodischen Ätzen kommt es nicht zu einer trichterförmigen Einschnürung wie dies im Stand der Technik der Fall ist. Aufgrund der Möglichkeit zum Erzeugen deutlich tieferer Kanalstrukturen kann die Anzahl der Einzelschichten innerhalb eines vertikalen Schichtstapels signifikant erhöht werden, sodass dementsprechend die Speicherkapazität eines dadurch herstellbaren dreidimensional integrierten Halbleiterspeichers deutlich erhöht werden kann.

Einige Ausführungsbeispiele der vorliegenden Erfindung sind exemplarisch in der Zeichnung dargestellt und werden nachstehend erläutert. Es zeigen:
- Figs. 1A-1E: schematische seitliche Schnittansichten zur Versinnbildlichung einzelner Verfahrensschritte zum Herstellen eines konventionellen 3D Halbleiterspeichers mit herkömmlichen Verfahren gemäß dem Stand der Technik,
- Fig. 1F: einen Ausschnitt einer schematischen seitlichen Schnittansicht einer vertikalen Ausnehmung in einem herkömmlichen Schichtstapel gemäß dem Stand der Technik zur Verdeutlichung der mit den bisher eingesetzten Methoden bestehenden Problematiken, und
- Fig. 2: eine schematische seitliche Schnittansicht eines Schichtstapels, wie er nach dem erfindungsgemäßen Verfahrensschritt erzeugbar ist, und
- Figs. 3A-3N: schematische seitliche Schnittansichten zur Versinnbildlichung einzelner (teils optionaler) Verfahrensschritte zum Herstellen eines erfindungsgemäßen 3D Halbleiterspeichers mittels einem Verfahren gemäß der vorliegenden Erfindung.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die im Rahmen der vorliegenden Offenbarung abgebildet bzw. beschrieben sind, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

Sofern innerhalb dieser Offenbarung von einer vertikalen Richtung die Rede ist, so ist darunter diejenige Richtung zu verstehen, die senkrecht auf der von einer Einzelschicht aufgespannten Ebene steht. Wenn sich also beispielsweise eine Einzelschicht bezüglich ihrer Länge und Breite in der x-y-Ebene erstreckt, so entspräche die vertikale Richtung der z-Achse. In diesem Fall würden sich beispielsweise die Länge und Breite der Einzelschicht in x- bzw. y-Richtung bemessen, und die Dicke der Einzelschicht würde sich in z-Richtung bemessen. Innerhalb des Schichtstapels sind die jeweiligen Einzelschichten entlang ebendieser vertikalen Richtung (z-Achse) übereinander gestapelt, sodass sich der Schichtstapel, vom Substrat ausgehend, vertikal nach oben erstreckt.

Sofern innerhalb dieser Offenbarung von einer lateralen Richtung die Rede ist, so ist darunter diejenige Richtung zu verstehen, die innerhalb bzw. parallel zu der von einer Einzelschicht aufgespannten (x-y-) Ebene verläuft bzw. senkrecht zur vertikalen Erstreckungsrichtung (z-Achse) des Schichtstapels verläuft. Im Falle eines sich vertikal erstreckenden Schichtstapels kann die laterale Richtung also im Wesentlichen gleichbedeutend mit einer horizontalen Richtung sein.

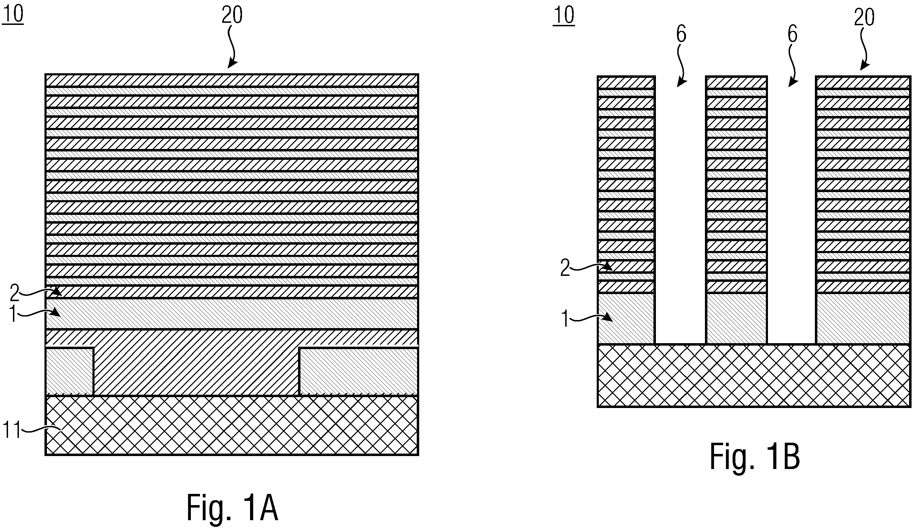

Bevor das erfindungsgemäße Verfahren beschrieben wird, soll zunächst kurz der Stand der Technik diskutiert werden. Die Figuren 1A bis 1E zeigen ein Verfahren zum Herstellen eines dreidimensional-integrierten Halbleiterspeichers 10 gemäß dem Stand der Technik. Wie in Figur 1A zu sehen ist, werden zunächst auf einem Siliziumsubstrat 11 mehrere Einzelschichten 1, 2 abwechselnd übereinander angeordnet. Dabei handelt es sich um Einzelschichten 1 aus Siliziumoxid (SiO₂) sowie um Einzelschichten 2 aus Siliziumnitrid (Si₃N₄). Diese abwechselnd übereinander angeordneten Einzelschichten 1, 2 bilden einen vertikalen Schichtstapel 20.

Figur 1B zeigt einen nächsten Prozessschritt, wobei ein oder mehrere vertikale Ausnehmungen 6 in den vertikalen Schichtstapel 20 strukturiert werden.

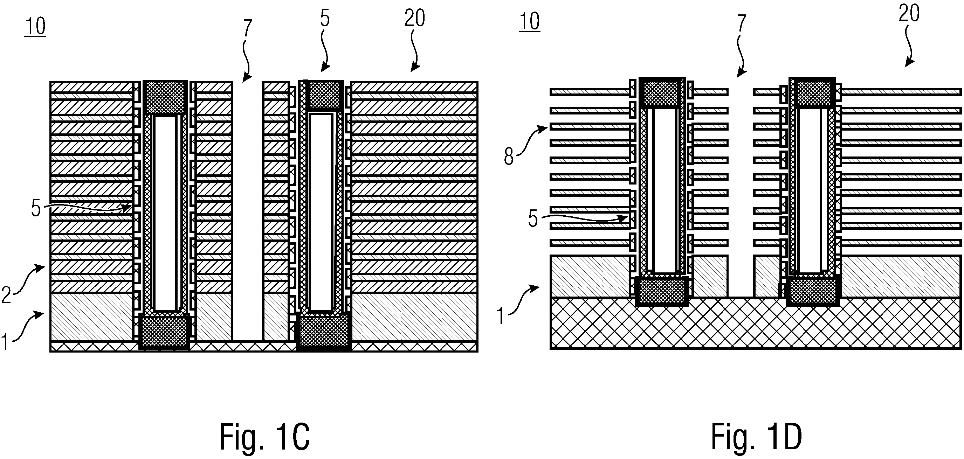

In Figur 1C ist zu sehen, dass in den vertikalen Ausnehmungen 6 Stützstrukturen 5 erzeugt werden können. Die Stützstrukturen 5 sind mit den Einzelschichten 1, 2 mechanisch verbunden und stabilisieren die Einzelschichten 1, 2. Die Stützstrukturen 5 können eine Gate-NAND-Struktur im Halbleiterspeicher bilden.

Zwischen den beiden Stützstrukturen 5 wird eine vertikale Kanalstruktur 7 in den Schichtstapel 20 strukturiert. Hierbei handelt es sich um das sogenannte "Hole Channel Etching". Durch die vertikale Kanalstruktur 7 werden die Einzelschichten 1, 2 lateral freigelegt, sodass die Einzelschichten 1, 2 innerhalb der vertikalen Kanalstruktur 7 frei zugänglich sind.

Im Zuge eines nasschemischen Ätzprozesses kann heiße Phosphorsäure durch die vertikale Kanalstruktur 7 in den Schichtstapel 20 eindringen. Dadurch gelangt die heiße Phosphorsäure zu den freigelegten Einzelschichten 1, 2 und ätzt hier selektiv die Siliziumnitrid-Einzelschichten 2 heraus, sodass nur die Siliziumoxid-Einzelschichten 1 bestehen bleiben (Figur 1D). Zwischen den Siliziumoxid-Einzelschichten 1 entstehen an den Stellen, wo zuvor die Siliziumnitrid-Einzelschichten 2 waren, Leerräume 8.

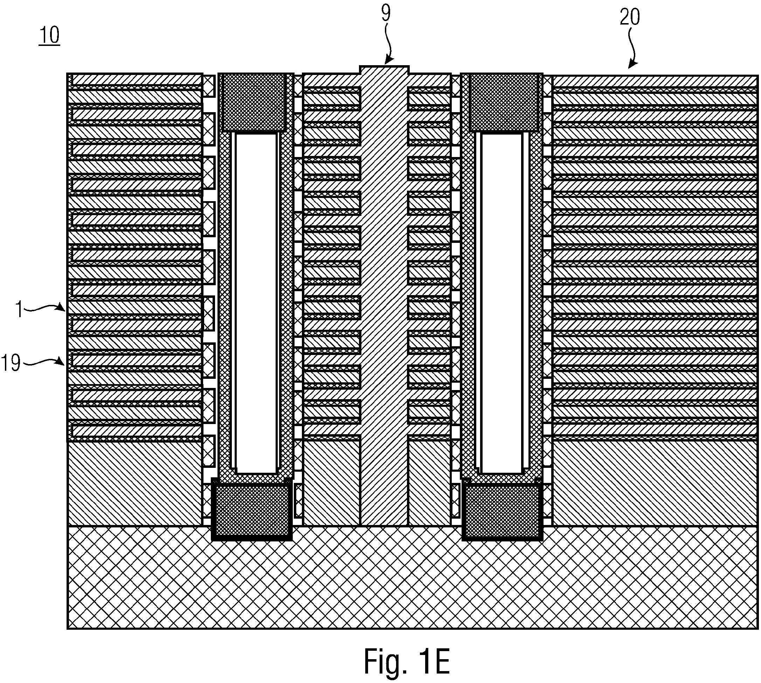

Wie in Figur 1E zu sehen ist, werden diese Leerräume 8 dann mit Wolfram 9 aufgefüllt. Im Ergebnis entsteht ein vertikaler Schichtstapel 20, der abwechselnd übereinander angeordnete Siliziumoxid-Einzelschichten 1 sowie Wolfram-Einzelschichten 19 aufweist.

Wie eingangs bereits erwähnt wurde, ist es ein Bestreben in der Herstellung von 3D NAND Speicherzellen, deren Speicherkapazität pro Volumen zu erhöhen. Dies wird unter anderem dadurch erreicht, dass immer mehr Einzelschichten aus Siliziumnitrid (Si₃N4₄) und Siliziumoxid (SiO₂) abwechselnd übereinander gestapelt werden, wodurch aber natürlich auch die Höhe des vertikalen Schichtstapels 20 insgesamt zunimmt. Um alle Siliziumnitrid-Einzelschichten 2 lateral ätzen zu können, wird die vertikale Kanalstruktur 7, wie zuvor erwähnt, in den Schichtstapel 20 eingebracht. Durch die vertikale Kanalstruktur 7 gelangt heiße Phosphorsäure zu den, innerhalb der vertikalen Kanalstruktur 7 jeweils freigelegten und zugänglich gemachten, Siliziumnitrid-Einzelschichten 2. Mit zunehmender Höhe des Schichtstapels 20 muss aber natürlich auch das Aspektverhältnis der vertikalen Kanalstruktur 7 entsprechend vergrößert werden, d.h. die vertikale Kanalstruktur 7 muss tiefer werden. Mit zunehmendem Aspektverhältnis kommt es jedoch zu immer mehr Ätzraten-Inhomogenitäten entlang der vertikalen Kanalstruktur 7, d.h. nach unten hin erhält man einen immer größer werdenden isotropen Anteil des ansonsten anisotropen Ätzverfahrens. Somit kommt es nach unten hin zu einer Art trichterförmigen Einschnürung der vertikalen Kanalstruktur 7..

Eine derartige trichterförmige Einschnürung kann dazu führen, dass der Schichtstapel 20 nicht vollständig durchätzt werden kann. Durch die Trichterform hat die vertikale Kanalstruktur 7 entlang ihrer Tiefe unterschiedliche Abmessungen, die die Zielgröße über- und unterschreiten können, was eine sinnvolle Herstellung des Speichers unmöglich macht.

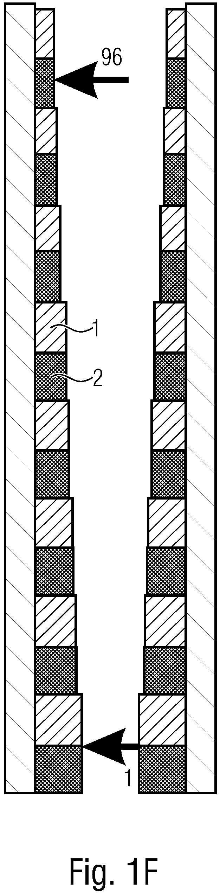

Figur 1F veranschaulicht dieses Problem. Hier ist, rein schematisch, ein Ausschnitt einer vertikalen Kanalstruktur 7 ("Channel Hole") innerhalb eines Schichtstapels mit mehreren, abwechselnd übereinander angeordneten, Einzelschichten 1, 2 abgebildet. Hierbei handelt es sich um Siliziumoxid-Schichten 1 und Siliziumnitrid-Schichten 2. Die Siliziumnitrid-Schichten 2 werden selektiv zu den Siliziumoxid-Schichten 1 geätzt.

Wie in Figur 1F zu sehen ist, kommt es beim Erzeugen der vertikalen Kanalstruktur ("Channel Hole Etching") zu einer trichterförmigen Einschnürung, wobei der Durchmesser am unteren Ende der vertikalen Kanalstruktur 7 deutlich geringer ist als der Durchmesser am oberen Ende der vertikalen Kanalstruktur 7.

Das daraus resultierende Problem ist eine Begrenzung der Anzahl der Einzelschichten innerhalb des Schichtstapels und der damit verbundenen Limitierung der Speicherkapazität. Das heißt, die vertikale Kanalstruktur 7 kann nicht beliebig tief ausgeführt werden, da es ansonsten zu immer deutlicher ausgeprägten Verengungen mit den hier gezeigten trichterförmigen Einschnürungen kommt. Heutzutage können etwa bis zu 96 Einzelschichten mit dieser Technik vertikal geätzt und anschließend selektiv lateral geätzt werden. Somit ist die Anzahl von Einzelschichten innerhalb eines Schichtstapels auf ebendiese 96 Einzelschichten begrenzt. Dies bedeutet jedoch auch, dass der Schichtstapel nicht wesentlich mehr Einzelschichten aufweisen darf, was jedoch die Speicherkapazität des Schichtstapels dementsprechend begrenzt.

Das hierin beschriebene neuartige Verfahren für das "Channel Hole Etching" bei der Herstellung von 3D Halbleiterspeichern ermöglicht es, die vertikalen Channel Holes über eine große Anzahl von Einzelschichten hinweg mit einer deutlich ausgeprägten Anisotropie zu erzeugen, wodurch es zu deutlich weniger ausgeprägten trichterförmigen Einschnürungen entlang des Channel Holes im vertikalen Schichtstapel kommt, sodass die Anzahl der Einzelschichten innerhalb eines Schichtstapels signifikant erhöht werden kann, um die Speicherkapazität des Halbleiterspeichers dementsprechend zu steigern.

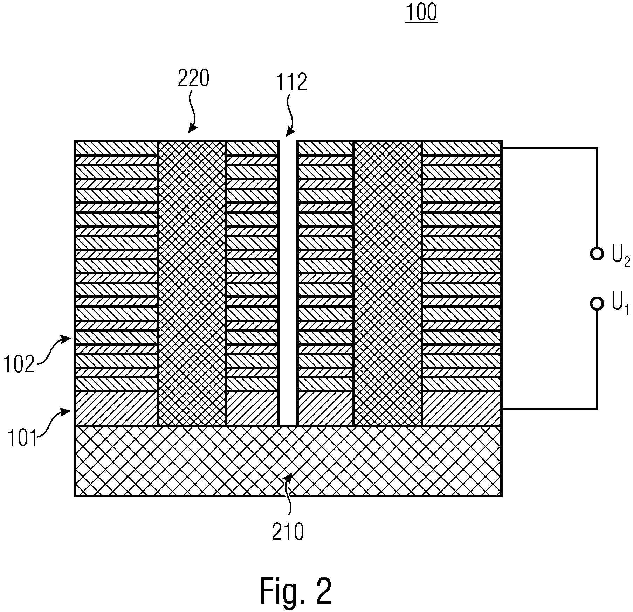

Figur 2 zeigt zunächst eine schematische Ansicht eines erfindungsgemäßen vertikalen Schichtstapels 100 mit einer vertikalen Kanalstruktur 112 ("Channel Hole"), die unter Anwendung eines erfindungsgemäßen Verfahrens ("Channel Hole Etching") erzeugt wurde. Diese vertikale Kanalstruktur 112 wird auch als "Channel Hole" bezeichnet und kann beispielsweise die Form eines Lochs aufweisen.

Bei dem erfindungsgemäßen Verfahren wird zunächst ein Substrat 200 bereitgestellt. Auf dem Substrat 200 wird ein Schichtstapel 100 erzeugt. Der Schichtstapel 100 weist mehrere Einzelschichten 101, 102 auf. Dieser Schichtstapel 100 wird hergestellt, indem abwechselnd mehrere Einzelschichten 101 eines ersten Materials sowie mehrere Einzelschichten 102 eines unterschiedlichen zweiten Materials übereinander aufgetragen werden. Die Einzelschichten 101, 102 können zum Beispiel abwechselnd abgeschieden oder epitaktisch gewachsen werden.

Erfindungsgemäß sind sowohl das erste Material als auch das zweite Material jeweils elektrisch leitend oder halbleitend. Beispielsweise können die Einzelschichten 101 des ersten Materials ein erstes dotiertes Halbleitermaterial aufweisen oder aus einem ersten dotierten Halbleitermaterial bestehen. Alternativ oder zusätzlich können die Einzelschichten 102 des zweiten Materials ein zweites dotiertes Halbleitermaterial aufweisen oder aus einem zweiten dotierten Halbleitermaterial bestehen, wobei das erste und das zweite dotierte Halbleitermaterial unterschiedlich sind.

Hierbei wäre es beispielsweise denkbar, dass das erste dotierte Halbleitermaterial im Vergleich zum zweiten dotierten Halbleitermaterial einen unterschiedlichen Dotierungstyp oder einen unterschiedlichen Dotierungsgrad aufweist. Unter dem Dotierungsgrad, der auch als Dotierungsstärke bezeichnet wird, versteht man die Stärke der Dotierung. Hierbei kann unterschieden werden zwischen einer starken Dotierung (n⁺; p⁺), einer mittleren Dotierung (n; p) und einer schwachen Dotierung (n⁻, p⁻).

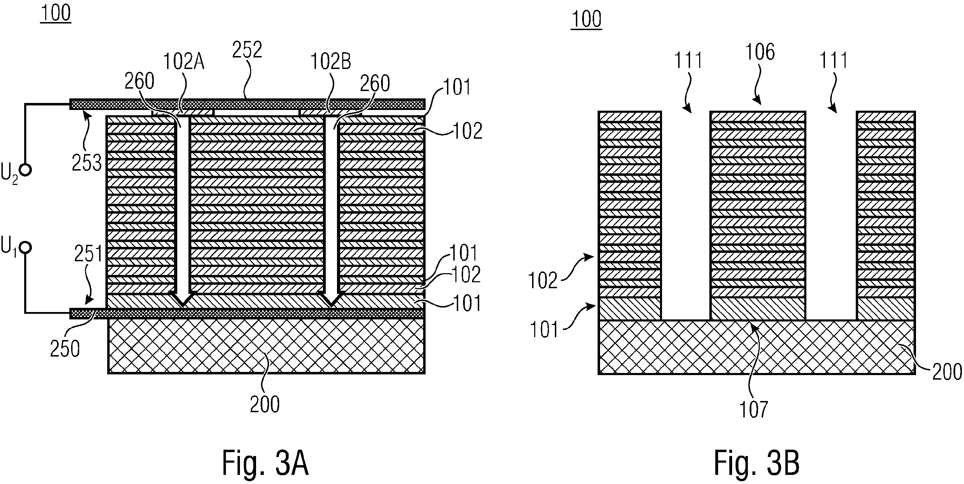

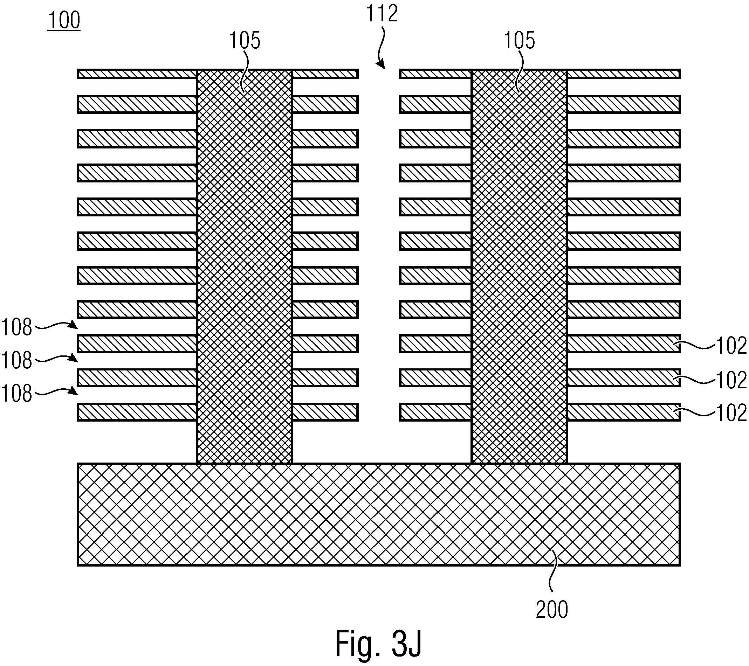

Aufgrund der unterschiedlichen Dotierung (d.h. unterschiedlicher Dotierungstyp und/oder unterschiedlicher Dotierungsgrad) weisen die beiden Halbleitermaterialien auch ein unterschiedliches Ätzverhalten auf. Somit kann in einem späteren Verfahrensschritt (Figur 3J) das eine Halbleitermaterial selektiv zu dem jeweils anderen Halbleitermaterial geätzt werden. Das selektive Ätzen, und die damit verbundene Notwendigkeit einer möglichst großen Ätzselektivität des einen Materials gegenüber dem anderen Material, wird später, unter Bezugnahme auf die Figuren 3A bis 3N, noch näher erläutert.

Das erfindungsgemäße Verfahren sieht nämlich vor, dass in dem vertikalen Schichtstapel 100 mindestens eine vertikale Kanalstruktur 112 ("Channel Hole") strukturiert wird. Diese vertikale Kanalstruktur 112 wird erfindungsgemäß unter Anwendung eines anodischen Ätzvorgangs in den Schichtstapel 100 strukturiert. Zum Zwecke des anodischen Ätzens ist es vorteilhaft, wenn beide Einzelschichten 101, 102 elektrisch leitend oder halbleitend sind.

Wie in Figur 2 beispielhaft gezeigt ist, kann zum Ausführen des anodischen Ätzvorgangs ein erstes elektrisches Potential U₁ an einem ersten Abschnitt 210 des Schichtstapels 100 angelegt werden. Zudem kann an einem unterschiedlichen zweiten Abschnitt 220 des Schichtstapels 100 ein von dem ersten elektrischen Spannungspotential U₁ unterschiedliches zweites elektrisches Spannungspotential U₂ angelegt werden. Dadurch fließt zwischen dem ersten Abschnitt 210 und dem zweiten Abschnitt 220 ein elektrischer Strom durch den Schichtstapel 100 hindurch, der durch gerichtetes anodisches Ätzen die vertikale Kanalstruktur 112 in dem Schichtstapel 100 erzeugt.

Bei dem ersten Abschnitt 210 des Schichtstapels 100 kann es sich beispielsweise um einen dem Substrat 200 zugewandten oder nächstgelegenen Abschnitt 210 des Schichtstapels 100 handeln. Der erste Abschnitt 210 des Schichtstapels 100 kann beispielsweise eine Unterseite des Schichtstapels 100 sein. Dabei kann es sich beispielsweise um die unterste, d.h. dem Substrat 200 nächstgelegene, Einzelschicht handeln.

Bei dem zweiten Abschnitt 220 des Schichtstapels 100 kann es sich beispielsweise um einen dem Substrat 200 abgewandten oder entfernt gelegensten Abschnitt 220 des Schichtstapels 100 handeln. Der zweite Abschnitt 220 des Schichtstapels 100 kann beispielsweise eine Oberseite des Schichtstapels 100 sein. Dabei kann es sich beispielsweise um die oberste, d.h. dem Substrat 200 entfernt gelegenste, Einzelschicht 101, 102 handeln.

Es wäre aber ebenso denkbar, dass es sich bei dem ersten Abschnitt 210 des Schichtstapels 100 um eine beliebige Einzelschicht in der unteren Hälfte des Schichtstapels 100 handelt, und dass es sich bei dem zweiten Abschnitt 220 des Schichtstapels 100 um eine beliebige Einzelschicht 101, 102 in der oberen Hälfte des Schichtstapels 100 handelt.

Dies kann sich unter anderem danach richten, wie tief geätzt werden soll, das heißt bis zu welcher Tiefe die vertikale Kanalstruktur 112 erzeugt werden soll. Wenn also beispielsweise die vertikale Kanalstruktur 112 durch den gesamten Schichtstapel 100 hindurch, bis hinunter zum Substrat 200, strukturiert werden soll, dann kann der erste Abschnitt die Unterseite bzw. die unterste Einzelschicht 101, 102 des Schichtstapels 100 sein. Soll jedoch nur bis zu einer bestimmten Einzelschicht in der unteren Hälfte des Schichtstapels 100 geätzt werden, so kann das erste Potential U₁ an ebendieser bestimmten Einzelschicht angelegt werden.

Figur 2 zeigt lediglich eine schematische Ansicht des Schichtstapels 100, wobei die jeweilige Einzelschicht 101, 102 direkt kontaktiert wird. Es wäre aber auch denkbar, dass eine (hier nicht explizit dargestellte) erste Elektrodenstruktur mit dem ersten Abschnitt 210 (z.B. mit der untersten Einzelschicht) des Substratstapels 100 und/oder eine (hier nicht explizit dargestellte) zweite Elektrodenstruktur mit dem zweiten Abschnitt 220 (z.B. mit der obersten Einzelschicht) des Substratstapels 100 in Kontakt ist. Somit könnte eine elektrische Spannung an die jeweiligen Elektrodenstrukturen angeschlossen werden. Auch dies wird nachfolgend noch näher erläutert.

Das erste elektrische Potential U₁ kann einen ersten Betrag aufweisen, während das zweite elektrische Spannungspotential U₂ einen davon unterschiedlichen zweiten Betrag aufweisen kann. Beispielsweise kann das erste elektrische Spannungspotential U₁ ein Massepotential sein, während das zweite elektrische Spannungspotential U₂ einen vom Massepotential unterschiedlichen Betrag mit positivem oder negativem Vorzeichen aufweisen kann.

Der dadurch entstehende elektrische Strom fließt demnach, in Abhängigkeit seines Vorzeichens, in vertikaler Richtung durch den vertikalen Schichtstapel 100 hindurch. Das heißt, der elektrische Strom fließt beispielsweise von dem ersten Abschnitt 210 (z.B. Unterseite) des Schichtstapels 100 in Richtung des zweiten Abschnitts 220 (z.B. Oberseite) des Schichtstapels 100 in vertikaler Richtung durch den Schichtstapel 100 hindurch und erzeugt dabei die vertikale Kanalstruktur 112. Der elektrische Strom würde in diesem Beispiel also von unten nach oben fließen.

Die vertikale Kanalstruktur 112 ("Channel Hole") dient unter anderem dazu, um einen Zugang für ein Ätzmedium in das Innere des Schichtstapels 100 zu schaffen. Mittels des durch das Channel Hole 112 in den Schichtstapel 100 eindringenden Ätzmediums können, im Rahmen der Herstellung eines dreidimensional integrierten Halbleiterspeichers, die Einzelschichten 101 des einen Materials selektiv zu den Einzelschichten 102 des jeweils anderen Materials geätzt werden.

Die Figuren 3A bis 3N zeigen schematisch einzelne Verfahrensschritte zum Erzeugen eines dreidimensional integrierten Halbleiterspeichers unter Anwendung des erfindungsgemäßen Verfahrens. Das erfindungsgemäße Verfahren bezieht sich dabei auf einen bestimmten Schritt während des Prozesses zum Herstellen eines dreidimensional integrierten Halbleiterspeichers. Dieser erfindungsgemäße Prozessschritt ("Channel Hole Etching") dient zum Erzeugen einer vertikalen Kanalstruktur 112 ("Channel Hole"), und wird erfindungsgemäß unter Anwendung eines anodischen Ätzprozesses ausgeführt.

Figur 3A zeigt zunächst einen vertikalen beziehungsweise dreidimensionalen Schichtstapel 100 in einem Ausgangs- bzw. Anfangszustand. Der Schichtstapel 100 ist auf einem Substrat 200 angeordnet. Der Schichtstapel 100 kann erzeugt werden, indem auf dem Substrat 200 abwechselnd mehrere Einzelschichten 101 eines ersten Materials sowie mehrere Einzelschichten 102 eines unterschiedlichen zweiten Materials aufgetragen werden. Die Einzelschichten 101, 102 können beispielsweise übereinander abgeschieden oder epitaktisch gewachsen werden.

Die Einzelschichten 101, 102 beziehungsweise die Materialien der Einzelschichten 101, 102 sind dabei derart gewählt, dass diese eine sehr hohe Ätzselektivität relativ zueinander aufweisen. Beispielsweise können die Einzelschichten 101 des ersten Materials Germanium (Ge) oder Siliziumgermanium (SiGe) aufweisen oder aus Germanium bzw. Siliziumgermanium bestehen. Die Einzelschichten 102 des zweiten Materials hingegen können Silizium (Si) aufweisen oder aus Silizium bestehen.

Wie eingangs erwähnt wurde, kann eine hohe Ätzselektiv zwischen den beiden Arten von Einzelschichten 101, 102 auch dadurch erreicht werden, dass die Einzelschichten 101, 102 jeweils unterschiedliche Dotierungstypen und/oder Dotierungsgrade aufweisen. Der Grund weshalb eine hohe Ätzselektivität zwischen den Einzelschichten 101 des ersten Materials und den Einzelschichten 102 des zweiten Materials bestehen sollte, wird nachfolgend unter Bezugnahme auf 3J noch näher erläutert werden.

Neben der Ätzselektivität hat der Dotierungstyp bzw. der Dotierungsgrad noch einen weiteren Grund. Zum Zwecke des nachfolgend näher beschriebenen anodischen Ätzens ist es nämlich von Vorteil, wenn beide Arten von Einzelschichten 101, 102, d.h. sowohl die Einzelschichten 101 des ersten Materials als auch die Einzelschichten 102 des zweiten Materials, jeweils elektrisch leitfähig sind. Auch dies kann mittels des Dotierungstyps und/oder des Dotierungsgrads der jeweiligen Einzelschichten 101, 102 eingestellt werden.

Bei dem erfindungsgemäßen Verfahren können die Einzelschichten 101 des ersten Materials und/oder die Einzelschichten 102 des zweiten Materials außerdem in amorpher Struktur vorliegen. Das heißt, die Einzelschichten 101, 102 müssen nicht zwingend eine kristalline Struktur aufweisen. Beispielsweise können also die Einzelschichten 101, 102 amorphes Silizium bzw. amorphes Siliziumgermanium aufweisen bzw. daraus bestehen.

In dem in Figur 3A abgebildeten Beispiel ist rein beispielhaft eine Einzelschicht 101 des ersten Materials (z.B. SiGe) als unterste bzw. erste Schicht auf dem Substrat 200 angeordnet. Auf diese erste Einzelschicht 101 werden dann weitere Einzelschichten 102 des zweiten Materials sowie weitere Einzelschichten 101 des ersten Materials jeweils abwechselnd übereinander angeordnet. Dadurch ergibt sich ein vertikaler Schichtstapel 100 mit mehreren abwechselnd übereinander angeordneten Einzelschichten 101, 102 des ersten und zweiten Materials. Die Reihenfolge der Einzelschichten 101, 102 kann aber auch vertauscht sein, sodass beispielsweise eine Einzelschicht 102 des zweiten Materials als erste Schicht auf dem Substrat 200 angeordnet wird.

Es wäre denkbar, dass zwischen dem Substrat 200 und der untersten Einzelschicht 101, 102 eine erste Elektrodenstruktur 250 angeordnet ist. Diese erste Elektrodenstruktur 250 kann einen Kontaktabschnitt 251 zur elektrischen Kontaktierung aufweisen. An dem Kontaktabschnitt 251 kann ein elektrisches Potential U₁ angelegt werden. Das Element, an dem das erste elektrische Potential U₁ anliegt, wird auch als erster Potentialkontakt bezeichnet.

Das erste elektrische Potential U₁ kann einen bestimmten Wert aufweisen. Beispielsweise kann das erste elektrische Potential U₁ ein Massepotential sein.

Die erste Elektrodenstruktur 250 kann elektrisch leitend mit der ersten bzw. untersten Einzelschicht 101 des Schichtstapels 100 verbunden sein, sodass die unterste Einzelschicht 101 ebenfalls auf dem ersten elektrischen Potential U₁ liegt und somit den ersten Potentialkontakt bildet. Anstelle der ersten Elektrodenstruktur 250 kann die unterste Einzelschicht 101 auch direkt kontaktiert werden, wie dies zuvor beispielhaft, unter Bezugnahme auf Figur 2, erläutert wurde.

Auf einer dem Substrat 200 gegenüberliegenden Seite, d.h. auf der Oberseite des Schichtstapels 100 ist eine letzte bzw. oberste Einzelschicht angeordnet. In dem in Figur 3A gezeigten Beispiel handelt es sich um eine Einzelschicht 102 des zweiten Materials. Es wäre aber ebenso denkbar, dass eine Einzelschicht 101 des ersten Materials die oberste Schicht bildet.

Auf dieser obersten Schicht 102 kann eine zweite Elektrodenstruktur 252 angeordnet sein. Hierbei kann die oberste Schicht 102 vordefiniert strukturiert sein. Hierzu sei auf die Figur 3B vorweggegriffen. Dort ist zu sehen, dass ein oder mehrere vertikale Ausnehmungen 111 erzeugt werden sollen.

Wie wiederum in Figur 3A zu sehen ist, kann die oberste Schicht 102 derart strukturiert sein, dass Teile 102A der obersten Schicht 102 an denjenigen Stellen verbleiben, an denen im nachfolgenden Prozessschritt (Figur 3B) die vertikalen Ausnehmungen 111 (Figur 3B) entstehen sollen. An anderen Stellen, d.h. an Stellen, an denen später keine Ausnehmungen 111 entstehen sollen, kann die oberste Schicht 102 entfernt werden.

Die obenliegende zweite Elektrodenstruktur 252 kann nun auf der strukturierten obersten Schicht 102, bzw. auf den bestehenbleibenden Abschnitten 102A der strukturierten obersten Schicht 102, angeordnet werden, sodass die strukturierte oberste Schicht 102 elektrisch leitend mit der zweiten Elektrodenstruktur 252 kontaktiert ist.

Die zweite Elektrodenstruktur 252 kann einen Kontaktabschnitt 253 zur elektrischen Kontaktierung aufweisen. An dem Kontaktabschnitt 253 kann ein zweites elektrisches Potential U₂ angelegt werden. Das Element, an dem das zweite elektrische Potential U₂ anliegt, wird auch als zweiter Potentialkontakt bezeichnet.

Das elektrische Potential U₂ kann einen von dem ersten elektrischen Potential U₁ unterschiedlichen Wert aufweisen, sodass sich ein Potentialgefälle bzw. eine elektrische Spannung ausbildet. Hierbei kann es sich um eine elektrische Wechselspannung oder um eine Gleichspannung handeln.

Da die zweite Elektrodenstruktur 252 elektrisch leitend mit der letzten bzw. obersten strukturierten Einzelschicht 102 des Schichtstapels 100 verbunden ist, liegt die oberste strukturierte Einzelschicht 102 ebenfalls auf dem elektrischen Potential U₂. In diesem Beispiel bildet also die strukturierte oberste Einzelschicht 102 den zweiten Potentialkontakt. Die oberste strukturierte Einzelschicht 102 kann aber auch direkt kontaktiert werden, wie dies zuvor beispielhaft, unter Bezugnahme auf Figur 2, erläutert wurde.

Eines der beiden elektrischen Potentiale U₁, U₂ kann ein Massepotential sein. Die sich an den beiden Potentialkontakten, aufgrund der Potentialdifferenz, einstellende elektrische Spannung kann in Form einer Gleichspannung oder in Form einer Wechselspannung vorliegen. Beispielsweise kann also zwischen dem ersten Potentialkontakt, bzw. einem ersten Abschnitt 210 des Schichtstapels 100 (z.B. die unterste Einzelschicht 101), und dem zweiten Potentialkontakt, bzw. einem zweiten Abschnitt 220 des Schichtstapels 100 (z.B. die oberste strukturierte Einzelschicht 102), eine Gleichspannung oder eine Wechselspannung angelegt werden. Hierfür kann beispielsweise eine geeignete Spannungsquelle an den beiden Elektroden 250, 252 bzw. Potentialkontakten angeschlossen werden.

Aufgrund der angelegten Spannung, bzw. aufgrund der Potentialdifferenz zwischen den beiden elektrischen Potentialen U₁ und U₂, fließt ein elektrischer Strom 260 zwischen den beiden Potentialkontakten, in diesem Beispiel also zwischen der obersten strukturierten Schicht 102 und der untersten Schicht 101.

Wie in Figur 3B zu sehen ist, werden ein oder mehrere vertikale Ausnehmungen 111 in dem Schichtstapel 100 erzeugt. Diese vertikalen Ausnehmungen 111 werden in den Substratstapel 100 strukturiert. Hierfür kann ein anodisches Ätzverfahren angewendet werden.

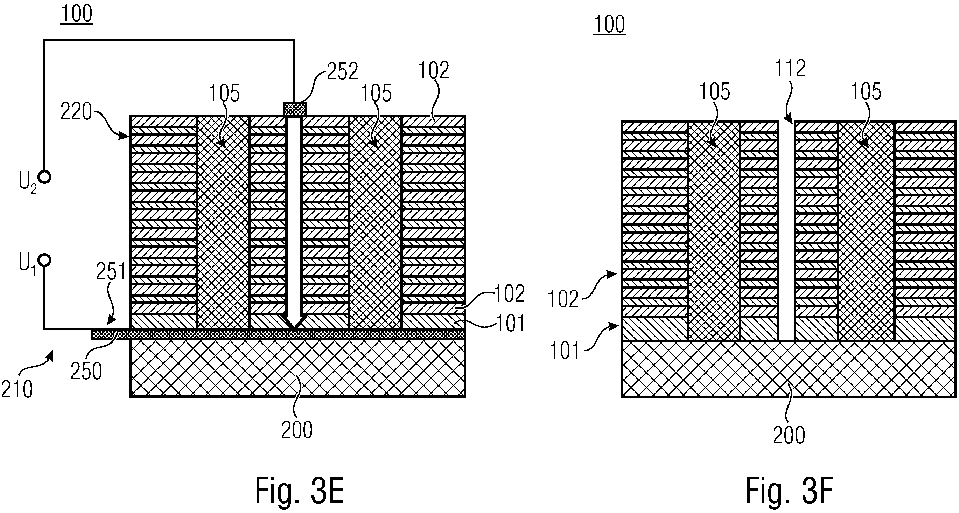

Es sei an dieser Stelle jedoch erwähnt, dass die Anwendung eines anodischen Ätzverfahrens zum Erzeugen der vertikalen Ausnehmungen 111 rein optional ist. Bei den vertikalen Ausnehmungen 111 handelt es sich nämlich nicht um sogenannte Channel Holes, sondern um Ausnehmungen, in denen später Stützstrukturen 105 (Figur 3E) erzeugt werden sollen. Diese Stützstrukturen 105 können beispielsweise eine Gate-NAND-Struktur bilden. Diese hier beschriebenen vertikalen Ausnehmungen 111 können somit auch mit anderen Ätzverfahren erzeugt werden.

Der erfindungsgemäße Prozessschritt bezieht sich auf den Schritt des sogenannten Channel Hole Etchings zum Erzeugen vertikaler Kanalstrukturen 112 ("Channel Holes"), was unter Bezugnahme auf die Figuren 3E bis 3H noch näher diskutiert wird. Hierfür wird erfindungsgemäß ein anodisches Ätzverfahren angewendet. Dadurch ergibt sich der Vorteil, dass der Schichtstapel 100 insgesamt mehr Einzelschichten 101, 102 aufweisen kann. Aus diesem Grund kann es sich aber demnach auch anbieten, die hier unter Bezugnahme auf die Figuren 3A bis 3D beschriebenen vertikalen Ausnehmungen 111 ebenfalls unter Anwendung eines anodischen Ätzverfahrens zu erzeugen. Nichtsdestotrotz bleibt dies rein optional.

Sofern also zum Erzeugen der vertikalen Ausnehmungen 111 ein anodisches Ätzverfahren angewendet wird, dann fließt der elektrische Strom 260 in dem in Figur 3A abgebildeten Beispiel also von dem zweiten Potentialkontakt (z.B. zweite Elektrodenstruktur 252 bzw. die damit kontaktierte letzte bzw. oberste strukturierte Einzelschicht 102) vertikal hinunter in Richtung des ersten Potentialkontakts (z.B. erste Elektrode 250 bzw. die damit verbundene erste bzw. unterste Einzelschicht 101).

Der elektrische Strom 260 kann hierbei durch den gesamten Schichtstapel 100 hindurchfließen und kann, in Stromflussrichtung, die übereinandergestapelten Einzelschichten 101, 102 entfernen, die sich zwischen dem ersten und zweiten Potentialkontakt befinden. Dies wird auch als anodisches Ätzen bezeichnet. Der Vorteil liegt darin, dass weit mehr als die bisher üblichen rund 100 Einzelschichten mit einer sehr hohen Anisotropie geätzt werden können. Das heißt, es bildet sich im Vergleich zum Stand der Technik keine in Ätzrichtung trichterförmig zulaufende Einschnürung der vertikalen Ausnehmungen 111 aus (siehe Figur 1F).

Wie in Figur 3B zu sehen ist, erstrecken sich die vertikalen Ausnehmungen 111 komplett bzw. vollständig durch den Schichtstapel 100, d.h. durch alle vorhandenen Einzelschichten 101, 102, hindurch. In anderen, hier nicht explizit dargestellten Ausführungsformen, wäre es aber auch denkbar, dass sich die mittels des anodischen Ätzens erzeugten vertikalen Kanalstrukturen 111 durch zumindest eine der Einzelschichten 101, 102, oder durch mehrere (aber nicht alle) Einzelschichten 101, 102 erstrecken. Dies ist abhängig davon, an welcher Einzelschicht das erste bzw. zweite elektrische Potential U₁, U₂ angelegt wird, d.h. welche Einzelschichten den ersten bzw. zweiten Potentialkontakt bilden. Da der elektrische Strom 260 nur zwischen den jeweiligen zwei Potentialkontakten (bzw. Einzelschichten) fließt, werden auch nur die jeweils zwischen diesen beiden Potentialkontakten (bzw. Einzelschichten) gelegenen Einzelschichten entfernt bzw. anodisch geätzt. Somit kann also beispielsweise eine vertikale Ausnehmung 111 innerhalb des Schichtstapels 100 erzeugt werden, die sich eben nur teilweise durch den Schichtstapel 100 hindurch erstreckt, zum Beispiel von einer Oberseite des Schichtstapels 100 bis nicht ganz hinunter zum Substrat 200.

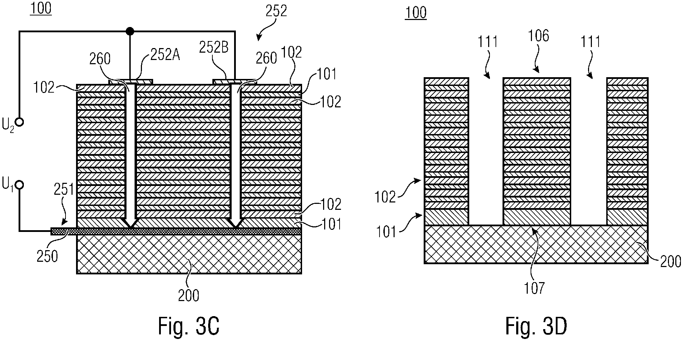

Figur 3C zeigt eine alternative Möglichkeit zum anodischen Ätzen der vertikalen Ausnehmungen 111, wobei gleiche Elemente wie in den Figuren 3A und 3B mit den gleichen Bezugszeichen versehen sind.

Auch hier ist zunächst ein Schichtstapel 100 mit mehreren abwechselnd übereinander angeordneten Einzelschichten 101 eines ersten Materials und Einzelschichten 102 eines zweiten Materials zu sehen. Die erste bzw. unterste Einzelschicht 101 kann, optional mittels einer ersten Elektrodenstruktur 250, einen ersten Potentialkontakt bilden. Der erste Potentialkontakt kann ein erstes elektrisches Potential U₁ aufweisen.

Ein Unterschied zu dem unter Bezugnahme auf Figur 3A diskutierten Ausführungsbeispiel liegt darin, dass eine zweite Elektrodenstruktur 252, optional mit mehreren Elektrodenabschnitten 252A, 252B, auf der letzten bzw. obersten Einzelschicht 102 des Schichtstapels 100 angeordnet sein kann. Die oberste Einzelschicht 102 kann, muss aber nicht, wie in Figur 3A strukturiert sein. Das heißt, in dieser Ausführungsform kann die letzte bzw. oberste Einzelschicht 102 in Gänze und somit unstrukturiert vorliegen.

Die zweite Elektrodenstruktur 252, bzw. deren Elektrodenabschnitte 252A, 252B, werden wiederum an denjenigen Stellen des Schichtstapels 100 angeordnet, an denen später die vertikalen Ausnehmungen 111 erzeugt werden sollen (Figur 3D).

Die zweite Elektrodenstruktur 252, bzw. deren Elektrodenabschnitte 252A, 252B, können einen zweiten Potentialkontakt bilden und an einem zweiten elektrischen Potential U₂ angeschlossen sein. Die zweite Elektrodenstruktur 252, bzw. deren Elektrodenabschnitte 252A, 252B, können sich auf der letzten bzw. obersten Einzelschicht 102, entlang einer Tiefenrichtung, d.h. in die abgebildete Zeichenebene hinein, erstrecken.

Zwischen dem ersten und dem zweiten Potentialkontakt fließt auch hier wieder ein elektrischer Strom 260, der die dazwischenliegenden Einzelschichten anodisch ätzt bzw. entfernt.

Wie in den nachfolgenden Figuren zu sehen ist, können die zuvor erzeugten vertikalen Ausnehmungen 111 mit einem Material befüllt werden, sodass sich innerhalb der jeweiligen vertikalen Ausnehmung 111 jeweils eine Stützstruktur 105 bildet. Diese Stützstruktur 105 ist mit den jeweiligen Einzelschichten 101, 102 verbunden, um diese mechanisch zu stabilisieren bzw. zu stützen.

Zum Erzeugen einer solchen Stützstruktur 105 können die vertikalen Ausnehmungen 111 beispielsweise mit einem Schichtsystem belegt bzw. gefüllt werden, welches das Kanalgebiet und die Isolatoren für das Gate und den Ladungsspeicher der späteren NAND-Speicherzelle bilden. Zur Belegung bzw. Füllung der vertikalen Ausnehmungen 111 werden Schichten verwendet um die Isolatoren und Kanal-Region des NAND-Speichers zu erzeugen (Gateisolator/Speicher und Kanal-Komponenten). Das zur Belegung bzw. Befüllung verwendete Material kann beispielsweise ein oder mehrere Komponenten aus der Gruppe von Siliziumoxid, Siliziumnitrid und Silizium aufweisen. Eine denkbare Schichtfolge kann sein (von innen nach außen): Siliziumoxid-Siliziumnitrid-Siliziumoxid-Silizium. Nach dem Befüllen kann die jeweilige vertikale Ausnehmung 111 durch Schichtabscheidungen verschlossen werden.

Die Figuren 3E bis 3H zeigen nun Prozessschritte ("Channel Hole Etching") die dem erfindungsgemäßen Verfahren zuzuordnen sind. Diese Prozessschritte dienen zum Erzeugen von vertikalen Kanalstrukturen 112 ("Channel Holes") in einem Schichtstapel 100 bei der Herstellung von dreidimensional integrierten Halbleiterspeichern.

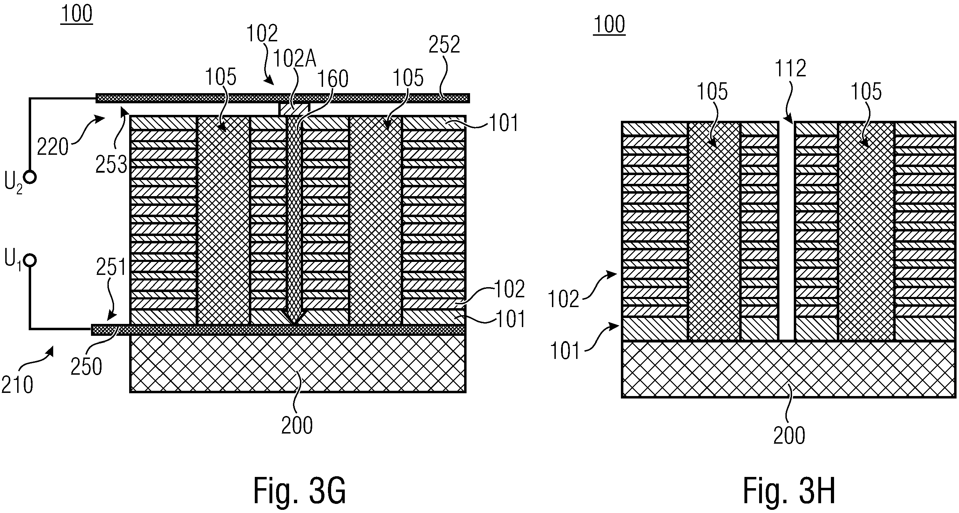

In dem Schichtstapel 100 kann nun eine vertikale Kanalstruktur 112 ("Channel Hole") erzeugt werden (siehe Figuren 3F und 3H). Die vertikale Kanalstruktur 112 kann hierbei beispielsweise zwischen den Stützstrukturen 105 (NAND-Gate-Struktur) gebildet werden. Während das anodische Ätzverfahren lediglich optional zum Erzeugen der zuvor beschriebenen vertikalen Ausnehmungen 111 angewendet werden kann, so ist das anodische Ätzen zum Erzeugen der nachfolgend, unter Bezugnahme auf die Figuren 3E bis 3H, beschriebenen vertikalen Kanalstruktur 112 ein erfindungsgemäßer Schritt des hierin offenbarten Verfahrens.

Wie in Figur 3E zu sehen ist, kann eine erste Elektrodenstruktur 250 zwischen dem Substrat 200 und der ersten bzw. untersten Einzelschicht 101, 102 angeordnet sein. Die erste Elektrodenstruktur 250 kann einen Kontaktabschnitt 251 zur elektrischen Kontaktierung aufweisen. An dem Kontaktabschnitt 251 kann ein elektrisches Potential U₁ angelegt werden. Das Element, an dem das erste elektrische Potential U₁ anliegt, wird auch als erster Potentialkontakt bezeichnet.

Das erste elektrische Potential U₁ kann einen bestimmten Wert aufweisen. Beispielsweise kann das erste elektrische Potential U₁ ein Massepotential sein.

Die erste Elektrodenstruktur 250 kann elektrisch leitend mit der ersten bzw. untersten Einzelschicht 101 des Schichtstapels 100 verbunden sein, sodass die unterste Einzelschicht 101 ebenfalls auf dem ersten elektrischen Potential U₁ liegt und somit den ersten Potentialkontakt bildet. Anstelle der ersten Elektrodenstruktur 250 kann die unterste Einzelschicht 101 auch direkt kontaktiert werden, wie dies zuvor beispielhaft, unter Bezugnahme auf Figur 2, erläutert wurde.

Auf einer dem Substrat 200 gegenüberliegenden Seite, d.h. auf der Oberseite, des Schichtstapels 100 ist eine letzte bzw. oberste Einzelschicht angeordnet. In dem in Figur 3E gezeigten Beispiel handelt es sich um eine Einzelschicht 102 des zweiten Materials. Es wäre aber ebenso denkbar, dass eine Einzelschicht 101 des ersten Materials die oberste Schicht bildet.

Auf dieser obersten Schicht 102 kann eine zweite Elektrodenstruktur 252 angeordnet sein. Hierbei kann die oberste Schicht 102 vordefiniert strukturiert sein. Wie in Figur 3F zu sehen ist, soll eine vertikale Kanalstruktur 112 ("Channel Hole") erzeugt werden, die im Herstellungsverfahren eines dreidimensional integrierten Halbleiterspeichers dazu genutzt wird, um ein Ätzmedium (z.B. Ätzgase, nasschemische Ätzlösungen, und dergleichen) in den Schichtstapel 100 einzuleiten. Das Ätzmedium wird genutzt, um die innerhalb der vertikalen Kanalstruktur 112 freigelegten Einzelschichten 101 des ersten Materials selektiv gegenüber den freigelegten Einzelschichten 102 des zweiten Materials zu ätzen bzw. zu entfernen. Das heißt, durch die vertikale Kanalstruktur 112 hindurch wird ein Ätzmedium eingeleitet, das eines der beiden Materialien selektiv zu dem jeweils anderen Material ätzt bzw. entfernt. Die Einzelschichten des einen Materials werden also entfernt, während die Einzelschichten des jeweils anderen Materials nicht entfernt werde, d.h. diese werden beibehalten. Dies unterscheidet die vertikale Kanalstruktur 112 von den zuvor diskutierten vertikalen Ausnehmungen 111. Wie bereits erwähnt, handelt es sich bei den Ausnehmungen 111 nicht um die sogenannten "Channel Holes".

Um nun die vertikale Kanalstruktur 112 mittels anodischem Ätzen zu erzeugen, kann die zweite Elektrodenstruktur 252 an denjenigen Stellen der obersten Einzelschicht 102 angeordnet werden, an denen später (Figur 3F) die vertikale Kanalstruktur 112 erzeugt werden soll.

Die zweite Elektrodenstruktur 252 kann an einem zweiten elektrischen Potential U₂ angeschlossen sein und dementsprechend einen zweiten Potentialkontakt bilden.

Zwischen dem ersten und dem zweiten Potentialkontakt fließt auch hier wieder ein elektrischer Strom 260, der die dazwischenliegenden Einzelschichten 101, 102 anodisch ätzt bzw. entfernt. Im Ergebnis entsteht hierbei die in Figur 3F gezeigte vertikale Kanalstruktur 112 ("Channel Hole").

Die erfindungsgemäß mittels des anodischen Ätverfahrens erzeugte vertikale Kanalstruktur 112 kann sich zwischen einem ersten bzw. unteren Abschnitt 210 (z.B. erster Potentialkontakt bzw. unterste Einzelschicht) des Schichtstapels 100 und einem zweiten bzw. oberen Abschnitt 220 (z.B. zweiter Potentialkontakt bzw. oberste Schicht) des Schichtstapels 100 im Wesentlichen geradlinig durch den Schichtstapel 100 hindurch erstrecken.

Die erfindungsgemäß mittels des anodischen Ätverfahrens erzeugte vertikale Kanalstruktur 112 kann außerdem ein Aspektverhältnis, bezüglich ihrer Länge zu Breite, von mehr als 50:1 oder mehr als 100:1 aufweisen.

Mit dem erfindungsgemäßen Verfahren können Schichtstapel 100 mit mehr als einhundert, zweihundert, oder sogar mit mehr als dreihundert, übereinander gestapelten Einzelschichten 101, 102 bearbeitet werden. Das heißt, es können mittels des anodischen Ätzens mehr als einhundert, zweihundert oder sogar mehr als dreihundert Einzelschichten 101, 102 geätzt bzw. entfernt werden, um eine vertikale Kanalstruktur 112 (Channel Hole") zu erzeugen. Es können sogar bis zu 1.000 oder mehr Einzelschichten 101, 102 bearbeitet werden. Das anodische Ätzen weist eine sehr hohe Anisotropie auf, weshalb die damit erzeugten vertikalen Kanalstrukturen 112, trotz ihres großen Aspektverhältnisses, über ihre gesamte Länge hinweg einen relativ konstanten Durchmesser aufweisen.

Die erfindungsgemäß mittels des anodischen Ätverfahrens erzeugte vertikale Kanalstruktur 112 kann beispielsweise einen Durchmesser zwischen 20 nm und 150 nm aufweisen. Der Durchmesser der vertikalen Kanalstruktur 112 kann über die gesamte Länge der Kanalstruktur 112 eine Abweichung von weniger als 10%, oder von weniger als 50% aufweisen, und somit in etwa konstant bleiben. Im Stand der Technik (Figur 1F) hingegen würde das Ätzen von mehr als den abgebildeten 96 Schichten dazu führen, dass sich die trichterförmige Einschnürung nach unten hin derart verjüngt, dass der Durchmesser im unteren Bereich der vertikalen Kanalstruktur 7 (Figur 1F) um mehr als 50% von dem Durchmesser im oberen Bereich abweicht.

Die Figuren 3G und 3H zeigen eine alternative Variante zum Erzeugen der vertikalen Kanalstruktur 112 mittels anodischem Ätzen, wobei gleiche Elemente wie in den Figuren 3E und 3F mit den gleichen Bezugszeichen versehen sind.

Auch hier ist zunächst ein Schichtstapel 100 mit mehreren abwechselnd übereinander angeordneten Einzelschichten 101 eines ersten Materials und Einzelschichten 102 eines zweiten Materials zu sehen. Die erste bzw. unterste Einzelschicht 101 kann, optional mittels einer ersten Elektrodenstruktur 250, einen ersten Potentialkontakt bilden. Der erste Potentialkontakt kann ein erstes elektrisches Potential U₁ aufweisen.

Ein Unterschied zu dem zuvor unter Bezugnahme auf Figur 3E diskutierten Ausführungsbeispiel liegt darin, dass eine zweite Elektrodenstruktur 252 auf der letzten bzw. obersten Einzelschicht 102 des Schichtstapels 100 angeordnet sein kann, wobei diese oberste Einzelschicht 102 vordefiniert strukturiert ist. Die oberste Schicht 102 kann derart strukturiert sein, dass mindestens ein Teil 102A der obersten Schicht 102 an denjenigen Stellen verbleibt, an denen im nachfolgenden Prozessschritt (Figur 3H) die vertikale Kanalstruktur 112 entstehen soll. An anderen Stellen, d.h. an Stellen, an denen später keine vertikale Kanalstruktur 112 entstehen soll, kann die oberste Schicht 102 entfernt werden.

Die zweite Elektrodenstruktur 252 kann nun auf der strukturierten obersten Schicht 102, bzw. auf dem bestehenbleibenden Abschnitt 102A der strukturierten obersten Schicht 102, angeordnet werden, sodass die strukturierte oberste Schicht 102 elektrisch leitend mit der Elektrodenstruktur 252 kontaktiert ist.

Die zweite Elektrodenstruktur 252 kann einen Kontaktabschnitt 253 zur elektrischen Kontaktierung aufweisen. An dem Kontaktabschnitt 253 kann ein zweites elektrisches Potential U₂ angelegt werden. Das Element, an dem das zweite elektrische Potential U₂ anliegt, wird auch als zweiter Potentialkontakt bezeichnet.

Das elektrische Potential U₂ kann einen von dem ersten elektrischen Potential U₁ unterschiedlichen Wert aufweisen, sodass sich ein Potentialgefälle bzw. eine elektrische Spannung ausbildet. Hierbei kann es sich um eine elektrische Wechselspannung oder um eine Gleichspannung handeln.

Da die zweite Elektrodenstruktur 253 elektrisch leitend mit der letzten bzw. obersten strukturierten Einzelschicht 102 des Schichtstapels 100 verbunden ist, liegt die oberste strukturierte Einzelschicht 102 ebenfalls auf dem elektrischen Potential U₂. In diesem Beispiel bildet also die strukturierte oberste Einzelschicht 102 den zweiten Potentialkontakt. Die oberste strukturierte Einzelschicht 102 kann aber auch direkt kontaktiert werden, wie dies zuvor beispielhaft, unter Bezugnahme auf Figur 2, erläutert wurde.

Eines der beiden elektrischen Potentiale U₁, U₂ kann ein Massepotential sein. Die sich an den beiden Potentialkontakten, aufgrund der Potentialdifferenz, einstellende elektrische Spannung kann in Form einer Gleichspannung oder in Form einer Wechselspannung vorliegen. Beispielsweise kann also zwischen dem ersten Potentialkontakt, bzw. einem ersten Abschnitt 210 des Schichtstapels 100 (z.B. die unterste Einzelschicht 101), und dem zweiten Potentialkontakt, bzw. einem zweiten Abschnitt 220 des Schichtstapels 100 (z.B. die oberste strukturierte Einzelschicht 102), eine Gleichspannung oder eine Wechselspannung angelegt werden. Hierfür kann beispielsweise eine geeignete Spannungsquelle an den beiden Elektroden 250, 252 bzw. Potentialkontakten angeschlossen werden.

Aufgrund der angelegten Spannung, bzw. aufgrund der Potentialdifferenz zwischen den beiden elektrischen Potentialen U₁ und U₂, fließt auch hier wieder ein elektrischer Strom 260 zwischen den beiden Potentialkontakten, in diesem Beispiel also zwischen der obersten strukturierten Schicht 102 und der untersten Schicht 101.

Der elektrische Strom 260 fließt in diesem Beispiel von dem zweiten Potentialkontakt (z.B. zweite Elektrodenstruktur 252 bzw. die damit kontaktierte letzte bzw. oberste strukturierte Einzelschicht 102) vertikal hinunter in Richtung des ersten Potentialkontakts (z.B. erste Elektrode 250 bzw. die damit verbundene erste bzw. unterste Einzelschicht 101).

Wie dann in Figur 3H zu sehen ist, wird entlang der Stromflussrichtung die vertikale Kanalstruktur 112 ("Channel Hole") in dem Schichtstapel 100 erzeugt. Die vertikale Kanalstruktur 112 wird erfindungsgemäß also mittels eines anodischen Ätzverfahrens in den Schichtstapel 100 strukturiert.

Der elektrische Strom 260 kann hierbei durch den gesamten Schichtstapel 100 hindurchfließen und kann, in Stromflussrichtung, die übereinandergestapelten Einzelschichten 101, 102 entfernen, die sich zwischen dem ersten und zweiten Potentialkontakt befinden.

Wie in Figur 3H außerdem zu sehen ist, erstreckt sich die vertikale Kanalstruktur 112 komplett bzw. vollständig durch den Schichtstapel 100, d.h. durch alle vorhandenen Einzelschichten 101, 102, hindurch. In anderen, hier nicht explizit dargestellten Ausführungsformen, wäre es aber auch denkbar, dass sich die mittels des anodischen Ätzens erzeugte vertikale Kanalstruktur 112 durch zumindest eine der Einzelschichten 101, 102, oder durch mehrere (aber nicht alle) Einzelschichten 101, 102 erstreckt. Dies ist abhängig davon, an welcher Einzelschicht das erste bzw. zweite elektrische Potential U₁, U₂ angelegt wird, d.h. welche Einzelschichten den ersten bzw. zweiten Potentialkontakt bilden. Da der elektrische Strom 260 nur zwischen den jeweiligen zwei Potentialkontakten (bzw. Einzelschichten) fließt, werden auch nur die jeweils zwischen diesen beiden Potentialkontakten (bzw. Einzelschichten) gelegenen Einzelschichten entfernt bzw. anodisch geätzt. Somit kann also beispielsweise eine vertikale Kanalstruktur 112 innerhalb des Schichtstapels 100 erzeugt werden, die sich eben nur teilweise durch den Schichtstapel 100 hindurch erstreckt, zum Beispiel von einer Oberseite des Schichtstapels 100 bis nicht ganz hinunter zum Substrat 200.

Innerhalb der vertikalen Kanalstruktur 112 werden die Einzelschichten 101, 102 lateral freigelegt, d.h. die vertikale Kanalstruktur 112 bildet einen Zugang zu den jeweiligen Einzelschichten 101, 102 des Schichtstapels 100, in diesem Fall zu den im Schichtstapel 100 zu diesem Zeitpunkt vorhandenen Einzelschichten 101, 102 des ersten und zweiten Materials. Somit werden also innerhalb der vertikalen Kanalstruktur 112 die übereinander angeordneten Einzelschichten 101, 102 jeweils abschnittsweise freigelegt, sodass diese Einzelschichten 101, 102 über die vertikale Kanalstruktur 112 frei zugänglich sind.

Wie eingangs erwähnt wurde, dient die vertikale Kanalstruktur 112 im Herstellungsverfahren eines dreidimensional integrierten Halbleiterspeichers dazu, um ein Ätzmedium (z.B. Ätzgase, nasschemische Ätzlösungen, und dergleichen) in den Schichtstapel 100 einzuleiten. Dieses Ätzmedium wird genutzt, um die innerhalb der vertikalen Kanalstruktur 112 freigelegten Einzelschichten 101 des ersten Materials selektiv gegenüber den freigelegten Einzelschichten 102 des zweiten Materials zu ätzen bzw. zu entfernen. Das heißt, durch die vertikale Kanalstruktur 112 hindurch wird eines der beiden Materialien selektiv zu dem jeweils anderen Material geätzt bzw. entfernt bzw. herausgelöst.

Beispielsweise kann ein Ätzmedium durch die vertikale Kanalstruktur 112 in den Schichtstapel 100 einströmen und darin die jeweils zugänglich gemachten Einzelschichten 101, 102 des ersten und zweiten Materials erreichen.

Dementsprechend beinhaltet das erfindungsgemäße Verfahren einen Schritt des selektiven Entfernens der zugänglich gemachten Einzelschichten 101 des ersten Materials aus dem Schichtstapel 100, unter Beibehaltung der Einzelschichten 102 des zweiten Materials. Dies geschieht vorzugsweise unter Anwendung eines Ätzprozesses, bei dem ein Ätzmedium durch die vertikale Kanalstruktur 112 in den Schichtstapel 100 gelangt und dort die innerhalb der vertikalen Kanalstruktur 112 freigelegten und zugänglichen Einzelschichten 101, 102 des ersten und des zweiten Materials erreicht und selektiv lediglich die Einzelschichten eines der beiden Materialien aus dem Schichtstapel 100 herausätzt.

Aus dem oben genannten Grund ist es vorteilhaft, wenn die Einzelschichten 101 des ersten Materials eine hohe Ätzselektivität gegenüber den Einzelschichten 102 des zweiten Materials aufweisen. Wie eingangs erwähnt, kann dies unter anderem mittels der Dotierung (Dotierungstyp und/oder Dotierungsgrad) der jeweiligen Einzelschichten 101, 102 eingestellt werden.

Zum selektiven Herausätzen bestimmter Einzelschichten gelangt das, während dem hier zum Einsatz kommenden Ätzprozess genutzte Ätzmedium (z.B. Ätzgas) durch die vertikale Kanalstruktur 112 hindurch zunächst an die darin abschnittsweise freigelegten Einzelschichten 101, 102 des ersten und des zweiten Materials des Schichtstapels 100. Die beiden Materialien weisen, in Kombination mit dem eingesetzten Ätzmedium, eine sehr hohe Ätzselektivität relativ zueinander auf. Mittels dem eingesetzten Ätzmedium können die Einzelschichten des einen Materials sehr selektiv gegenüber den Einzelschichten des jeweils anderen Materials entfernt werden.

Beispielsweise kann das Ätzmedium die Einzelschichten 101 des ersten Materials selektiv zu den Einzelschichten 102 des zweiten Materials herausätzen, und zwar vorzugsweise in einer lateralen Richtung. Unter einer lateralen Richtung ist eine Richtung zu verstehen, die im Wesentlichen orthogonal zur (vertikalen) Schichtrichtung des Schichtstapels 100 verläuft. Die Schichtrichtung ist die Richtung in der die Einzelschichten 101 ,102 übereinander gestapelt werden, im vorliegenden Fall also beispielsweise vom Substrat 200 ausgehend vertikal nach oben. Die laterale Richtung wäre in diesem Fall beispielsweise eine etwa horizontale Richtung. Dementsprechend können die Einzelschichten 101 des ersten Materials, von der vertikalen Kanalstruktur 112 ausgehend, in etwa horizontaler Richtung aus dem Schichtstapel 100 herausgeätzt werden. Die Einzelschichten 102 des zweiten Materials werden hingegen nicht wesentlich von dem eingesetzten Ätzmedium angegriffen und werden somit nicht herausgeätzt, sondern sie verbleiben im Schichtstapel 100.

Figur 3J zeigt den nach dem selektiven Herausätzen der Einzelschichten 101 des ersten Materials entstehenden Schichtstapel 100. Dabei bleiben lediglich die Einzelschichten 102 des zweiten Materials übrig. Zwischen den verbleibenden Einzelschichten 102 des zweiten Materials entstehen, an den Stellen wo zuvor die mittlerweile entfernten Einzelschichten 101 des ersten Materials waren, Leerräume 108. Die verbleibenden Einzelschichten 102 des zweiten Materials stützen sich an den Stützstrukturen 105 ab. Die Stützstrukturen 105 wiederum sind mit dem Substrat 200 verbunden.

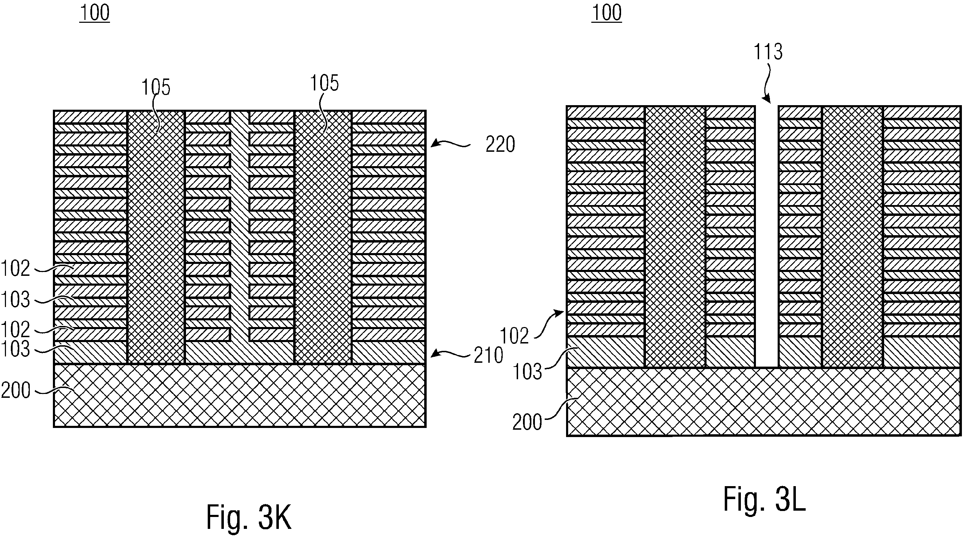

Figur 3K zeigt einen optionalen weiteren Prozessschritt zum Erzeugen eines dreidimensional integrierten Halbleiterspeichers. In die zwischen den Einzelschichten 102 des verbleibenden zweiten Materials entstandenen Leerräume 108 kann nun ein drittes Material eingebracht werden. Dabei bilden sich innerhalb dieser Leerräume 108 zwischen den verbleibenden Einzelschichten 102 des zweiten Materials jeweils Einzelschichten 103 des dritten Materials. Dadurch entsteht ein vertikaler Schichtstapel 100 mit abwechselnd übereinander angeordneten Einzelschichten 102 des zweiten Materials und Einzelschichten 103 des dritten Materials.

Das Einbringen des dritten Materials in die Leerräume 108 zwischen den bestehenbleibenden Einzelschichten 102 des zweiten Materials kann beispielsweise mittels eines additiven Trockenprozesses, vorzugsweise aus der Gasphase, ausgeführt werden. Beispielsweise kann das dritte Material unter Anwendung eines LPCVD-Prozesses (LPCVD: Low Pressure Chemical Vapor Deposition) in die Leerräume 108 eingebracht werden. Hierbei kann ein Prozessgas in die Prozesskammer (in der sich der Schichtstapel 100 befindet) eingeleitet werden. Das Prozessgas erreicht, unter anderem über die vertikale Kanalstruktur 112, die Leerräume 108 zwischen den Einzelschichten 102 des zweiten Materials und breitet sich in den Leerräumen 108 aus. Das Auftreffen der Gasmoleküle des Prozessgases auf den Einzelschichten 102 des zweiten Materials führt dazu, dass in den Leeräumen 108 das dritte Material (z.B. SiO₂) zwischen den bestehenbleibenden Einzelschichten 102 des zweiten Materials (z.B. Si) aufwächst.

Das dritte Material kann unterschiedlich zu dem zweiten Material sein. Vorzugsweise kann das dritte Material elektrisch isolierende Eigenschaften aufweisen. Das dritte Material kann beispielsweise Silizium(di-)oxid (SiO₂) aufweisen oder aus Silizium(di-)oxid bestehen.

Figur 3L zeigt einen weiteren optionalen Prozessschritt zum Erzeugen eines dreidimensional integrierten Halbleiterspeichers. Hier wird mindestens eine weitere vertikale Kanalstruktur 113 in den Schichtstapel 100 strukturiert. Diese weitere vertikale Kanalstruktur 113 kann, wie beispielhaft in Figur 3L gezeigt ist, wiederum zwischen den Stützstrukturen 105 erzeugt werden. Die weitere vertikale Kanalstruktur 112 kann außerdem, in der zuvor beschriebenen Art und Weise mittels eines anodischen Ätzverfahrens erzeugt werden.

Diese weitere vertikale Kanalstruktur 113 erstreckt sich ebenfalls von oben nach unten vertikal durch den Schichtstapel 100 hindurch, z.B. zwischen einem ersten Abschnitt 210 (z.B. Unterseite) des Schichtstapels 100 und einem zweiten Abschnitts 220 (z.B. Oberseite) des Schichtstapels 100. Diese weitere vertikale Kanalstruktur 113 erstreckt sich außerdem durch zumindest eine der Einzelschichten 102, 103, vorzugsweise durch mehrere Einzelschichten 102, 103, und weiter bevorzugt durch alle Einzelschichten 102, 103 des Schichtstapels 100 hindurch bis hinunter zum Substrat 200. In diesem Falle handelt es sich um Einzelschichten 102 des zweiten Materials und Einzelschichten 103 des dritten Materials.

Die weitere vertikale Kanalstruktur 113 bildet einen Zugang zu den jeweiligen Einzelschichten 102, 103 des Schichtstapels 100, in diesem Fall zu den im Schichtstapel 100 zu diesem Zeitpunkt vorhandenen Einzelschichten 102, 103 des zweiten und dritten Materials. Diese Einzelschichten 102, 103 des zweiten und dritten Materials werden demnach innerhalb der weiteren vertikalen Kanalstruktur 113 freigelegt und über diese weitere vertikale Kanalstruktur 113 zugänglich gemacht.

Auch diese weitere vertikale Kanalstruktur 113 kann als "Channel Hole" bezeichnet werden. Das erfindungsgemäße Verfahren beinhaltet somit auch das Erzeugen dieser weiteren vertikalen Kanalstruktur 113 unter Anwendung eines anodischen Ätzverfahrens, wobei alles was zuvor mit den Schichten 101 des ersten Materials und den Schichten 102 des zweiten Materials beschrieben wurde, in diesem Schritt (d.h. Erzeugen der vertikalen Kanalstruktur 113) analog für die Schichten 102 des zweiten Materials sowie für die Schichten 103 des dritten Materials gilt.

Ein weiterer optionaler Verfahrensschritt beinhaltet ferner ein selektives Entfernen der zugänglich gemachten Einzelschichten des einen Materials relativ zu den Einzelschichten des jeweils anderen Materials. Im vorliegenden Fall beinhaltet das Verfahren ein selektives Entfernen der Einzelschichten 102 des zweiten Materials selektiv zu den Einzelschichten 103 des dritten Materials. Dieses selektive Entfernen geschieht unter Anwendung eines in lateraler Richtung gerichteten Ätzprozesses mittels eines geeigneten Ätzmediums, das durch die weitere vertikale Kanalstruktur 113 in den Schichtstapel 100 eindringt. Das Ätzmedium kann bei diesem Ätzschritt ein Ätzgas (Trockenätzen) oder eine nasschemische Ätzlösung (Nassätzen) sein.

Im Falle eines Trockenätzprozesses kann dieser mindestens einen plasmaunterstützten Ätzschritt mit einem fluorhaltigen Gas beinhalten. Das Trockenätzen kann beispielsweise als isotroper CDE-Prozess (CDE: Chemical Dry Etching) mit einem fluorhaltigen Gas ausgeführt werden, wodurch beispielsweise Silizium (als denkbares Material der Einzelschichten 102) sehr selektiv zu SiO₂ (als denkbares Material der Einzelschichten 103) geätzt werden kann. Als Ätzgas kann beispielsweise SF₆ eingesetzt werden. Insbesondere Plasmaätzungen mit einem hohen SFe-Fluss, einem niedrigen O₂-Fluss und einem hohen Prozessdruck erlauben sehr selektive Ätzungen zwischen Si und SiO₂ mit einem isotropen Ätzverhalten, wie es für diese Ätzung gewünscht ist.

Das Ätzmedium (z.B. SFe-Gas) gelangt durch die weitere vertikale Kanalstruktur 113 hindurch zu den, innerhalb der weiteren vertikalen Kanalstruktur 113 freigelegten und zugänglich gemachten, Einzelschichten 102, 103 des zweiten und dritten Materials. Dabei entfernt das Ätzmedium die Einzelschichten 102 des zweiten Materials in lateraler Richtung selektiv zu den Einzelschichten 103 des dritten Materials, sodass nach dem selektiven Entfernen der Einzelschichten 102 des zweiten Materials lediglich die Einzelschichten 103 des dritten Materials verbleiben. Das heißt, die Einzelschichten 102 des zweiten Materials werden aus dem Schichtstapel 100 herausgeätzt.

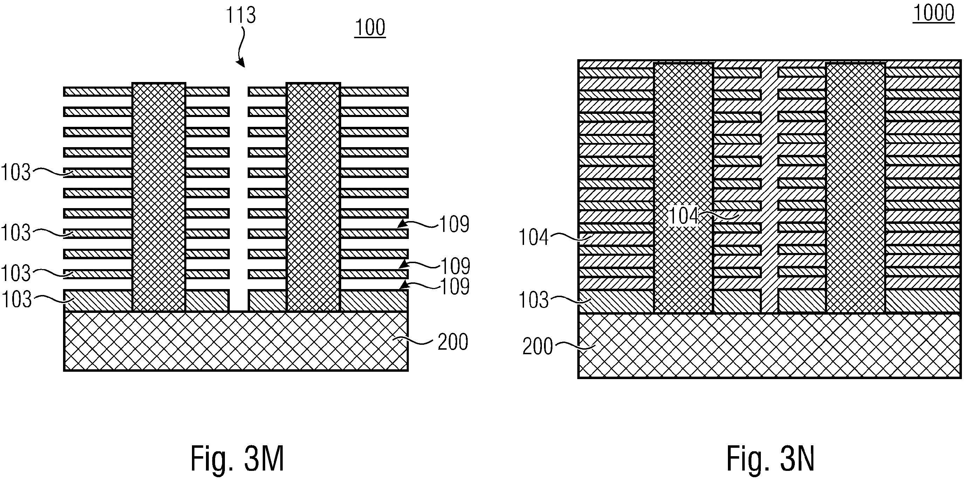

Figur 3M zeigt einen, nach dem selektiven Herausätzen der Einzelschichten 102 des zweiten Materials, entstehenden Schichtstapel 100. Dabei bleiben lediglich die Einzelschichten 103 des dritten Materials übrig. Zwischen den verbleibenden Einzelschichten 103 des dritten Materials entstehen, an den Stellen wo zuvor die mittlerweile entfernten Einzelschichten 102 des zweiten Materials waren, Leerräume 109. Die verbleibenden Einzelschichten 103 des dritten Materials stützen sich an den Stützstrukturen 105 ab.

Figur 3N zeigt einen optionalen weiteren Prozessschritt, an dessen Ende ein dreidimensional integrierter Halbleiterspeicher 1000 entsteht. In die zwischen den Einzelschichten 103 des verbleibenden dritten Materials entstandenen Leerräume 109 kann, unter anderem über die weitere vertikale Kanalstruktur 113, ein viertes Material eingebracht werden. Dabei bilden sich innerhalb dieser Leerräume 109 zwischen den verbleibenden Einzelschichten 103 des dritten Materials jeweils Einzelschichten 104 des vierten Materials. Dadurch entsteht ein vertikaler Schichtstapel 100 mit abwechselnd übereinander angeordneten Einzelschichten 103 des dritten Materials sowie Einzelschichten 104 des vierten Materials.

Das vierte Material kann unterschiedlich zu dem dritten Material sein. Vorzugsweise kann das vierte Material mindestens eine Komponente aus der Gruppe von Wolfram, Kobalt, Molybdän, dotiertem Silizium und Ruthenium aufweisen oder aus ebendieser Komponente bestehen. Die Einzelschichten 104 des vierten Materials können eine Word Line des nunmehr fertig erzeugten dreidimensional-integrierten Halbleiterspeichers 1000 bilden.

Bei dem dreidimensional-integrierten Halbleiterspeicher 1000 kann es sich insbesondere um einen 3D NAND Flash Speicher handeln. Gemäß einer denkbaren Ausführungsform kann der dreidimensional integrierte Halbleiterspeicher 1000 also beispielsweise ein 3D NAND-Flash-Speicher sein.

Die Gate-NAND-Struktur kann in einer der Stützstrukturen 105 integriert werden, oder nach dem Füllen des Schichtstapels 100 mit dem vierten Material (z.B. Wolfram) durch Erzeugen einer weiteren vertikalen Kanalstruktur im Schichtstapel 100 und Belegung dieser weiteren vertikalen Kanalstruktur mit entsprechenden Schichten erzeugt werden.

Für das hierin beschriebene erfindungsgemäße Verfahren hat es sich als besonders vorteilhaft herausgestellt, wenn die Einzelschichten 101 des ersten Materials Germanium (Ge) oder Siliziumgermanium (SiGe) aufweisen oder daraus bestehen. Ge bzw. SiGe kann sehr präzise mittels Trockenätzverfahren, insbesondere unter Anwendung von HCl-Gas, geätzt werden, und es weist zudem eine sehr hohe Selektivität gegenüber z.B. Silizium (als Material der Einzelschichten 102) auf. Außerdem sind sowohl Silizium als auch Siliziumgermanium elektrisch leitend, sodass diese Materialien hervorragend dazu geeignet sind, um eine vertikale Kanalstruktur 112 ("Channel Hole") unter Anwendung des hierin beschriebenen anodischen Ätzprozesses zu erzeugen. Im Stand der Technik werden Einzelschichten aus Siliziumoxid und Siliziumnitrid verwendet. Da Siliziumnitrid jedoch nicht leitfähig ist, kann hier kein anodisches Ätzverfahren angewendet werden.

Ein wesentlicher Vorteil beim anodischen Ätzen ist die sehr hohe Anisotropie, d.h. es kommt nicht mehr zu den aus dem Stand der Technik bekannten trichterförmigen Einschnürungen (Figur 1F). Dadurch kann die vertikale Kanalstruktur 112 durch deutlich mehr Einzelschichten 101, 102 hindurch erzeugt werden, sodass die Speicherkapazität des Schichtstapels 100 signifikant erhöht werden kann.

Die Grundidee des hierin beschriebenen Verfahrens besteht also unter anderem darin, vertikale Kanalstrukturen 112 (z.B. Löcher bzw. sog. "Channel Holes") mit extrem hohen Aspektverhältnissen und hoher Uniformität durch anodisches Ätzen herzustellen.

Hierfür wird leitendes/halbleitendes Material benötigt. Die Schichtfolgen können aus Si-SiGe Schichten 101, 102 bestehen, die als Multischichten (mehrere hundert Schichtfolgen) zum Beispiel epitaktisch gewachsen werden. Die Erfindung ist nicht auf kristalline Schichten beschränkt, da das anodische Ätzverfahren auch bei amorphen Materialen funktioniert. Entscheidend ist, dass die beide Materialien für das Multi-Schichtsystem halbleitend sind und durch unterschiedliches Ätzverhalten selektiv geätzt werden können. Die Ätzselektivität ist für die nachfolgende Herstellung der Flash-Zelle wichtig.

Alternativ zu Si-SiGe kann ein anderes Materialsystem verwendet werden, das folgende Eigenschaften hat: Man kann aus zwei unterschiedlichen Materialien A und B Schichtstapel 100 mit mehreren hundert Ebenen A-B-A-B-A-B ... erzeugen. Der gesamte Schichtstapel 100 hat eine Leitfähigkeit, sodass er sich mit einer anodischen Ätzung gerichtet ätzen lässt und somit die vertikalen Kanalstrukturen 112 ("Channel Holes") erzeugt werden können. Die Materialien A und B haben auf bestimmte Ätzmedien unterschiedliches Ätzverhalten, sodass man in einer späteren Ätzung Material A gegenüber Material B oder umgekehrt selektiv ätzen kann (Prozessfolge: (1) Herstellen der Mehrfach-Schichtstapel aus Material A und B, (2) Channel-Hole-Etch, (3) selektive Ätzung von A vs. B um die Speicherzellen herzustellen).

Durch Verwenden der anodischen Ätzung hat man die Möglichkeit extrem große Aspektverhältnisse zu erzielen. Außerdem besteht die Möglichkeit das "Hole Channel Etching" in Schichtsysteme mit vielen Schichten durchzuführen.

Gemäß einer denkbaren Ausführungsform kann während der Anwendung des anodischen Ätzverfahrens eine direkte Lichtquelle mit einer vorbestimmten Wellenlänge auf den Schichtstapel 100 gerichtet werden, um die Ladungsträgerdichte in dem Schichtstapel 100 zu erhöhen und dadurch den gerichteten anodischen Ätzvorgang zu unterstützen.

Bei der Lichtquelle handelt es sich um eine direkte Lichtquelle, die direkt auf den Schichtstapel 100 gerichtet wird. Diese Lichtquelle ist zusätzlich zu einer ansonsten im Prozessierungs-Raum (z.B. Reinraum) befindlichen Raumbeleuchtung vorhanden. Die Lichtquelle kann beispielsweise eine vorbestimmte Wellenlänge aufweisen, die größer ist als die Bandlücke des jeweiligen Materials der Einzelschichten 101, 102 des Schichtstapels 100.

Von der Lichtquelle ausgesendete Photonen können Elektronen in den jeweiligen Einzelschichten 101, 102 anregen. Dadurch kann die Ladungsträgerdichte in den jeweiligen Einzelschichten 101, 102 erhöht werden. Aufgrund einer erhöhten Ladungsträgerdichte kann der anodische Ätzvorgang optimiert werden. Das heißt, der anodische Ätzvorgang kann beispielsweise beschleunigt werden und/oder die gerichtete Ätzwirkung, d.h. die Anisotropie des anodischen Ätzvorgangs, kann erhöht werden.

Sofern mehrere Schichtstapel 100 auf einem Wafer erzeugt werden, so kann die Lichtquelle auf den Wafer gerichtet werden, um die darauf befindlichen Schichtstapel 100 auszuleuchten.

Die oben beschriebenen Ausführungsbeispiele stellen lediglich eine Veranschaulichung der Prinzipien des hierin beschriebenen innovativen Konzepts dar. Es versteht sich, dass Modifikationen und Variationen der hierin beschriebenen Anordnungen und Einzelheiten anderen Fachleuten einleuchten werden. Deshalb ist beabsichtigt, dass das hierin beschriebene Konzept lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

## Patentansprüche

1. Verfahren zum Erzeugen einer vertikalen Kanalstruktur (112) in einem Schichtstapel (100) bei der Herstellung von dreidimensional integrierten Halbleiterspeichern (1000), wobei das Verfahren die folgenden Schritte aufweist:
Bereitstellen eines Substrats (200) mit einem darauf angeordneten Schichtstapel (100) mit mehreren Einzelschichten (101, 102), wobei abwechselnd mehrere Einzelschichten (101) eines ersten Materials sowie mehrere Einzelschichten (102) eines unterschiedlichen zweiten Materials übereinander aufgetragen sind,
wobei das erste Material und das zweite Material jeweils elektrisch leitend oder halbleitend ist,
Erzeugen von mindestens einer vertikalen Kanalstruktur (112) in dem Schichtstapel (100), wobei sich die vertikale Kanalstruktur (112) in vertikaler Richtung zumindest abschnittsweise durch den Schichtstapel (100) hindurch erstreckt, sodass ein oder mehrere der Einzelschichten (101, 102) innerhalb der vertikalen Kanalstruktur (111, 112) freigelegt und durch die vertikale Kanalstruktur (112) zugänglich gemacht werden,
**dadurch gekennzeichnet, dass**
das Strukturieren der vertikalen Kanalstruktur (112) in dem Schichtstapel (100) unter Anwendung eines anodischen Ätzverfahrens ausgeführt wird, wobei ein erstes elektrisches Spannungspotential (U₁) an einem ersten Abschnitt (210) des Schichtstapels (100) angelegt wird, und wobei ein unterschiedliches zweites elektrisches Spannungspotential (U₂) an einem unterschiedlichen zweiten Abschnitt (220) des Schichtstapels (100) angelegt wird, wobei zwischen dem ersten und dem zweiten Abschnitt (210, 220) ein elektrischer Strom (260) vertikal durch den Schichtstapel (100) hindurch fließt, der durch gerichtetes anodisches Ätzen die vertikale Kanalstruktur (112) in dem Schichtstapel (100) erzeugt.

2. Verfahren nach Anspruch 1,
wobei die mittels des anodischen Ätverfahrens erzeugte vertikale Kanalstruktur (112) ein Aspektverhältnis bezüglich ihrer Länge zu Breite von mehr als 50:1 oder mehr als 100:1 aufweist.

3. Verfahren nach Anspruch 1 oder 2,
wobei die mittels des anodischen Ätverfahrens erzeugte vertikale Kanalstruktur (112) einen Durchmesser aufweist, der über die gesamte Länge der vertikalen Kanalstruktur (112) eine Abweichung von weniger als 50% aufweist und somit in etwa konstant bleibt.

4. Verfahren nach einem der vorhergehenden Ansprüche,
wobei sich die vertikale Kanalstruktur (112) geradlinig zwischen dem ersten Abschnitt (210) des Schichtstapels (100) und dem zweiten Abschnitt (220) des Schichtstapels (100) erstreckt.

5. Verfahren nach einem der vorhergehenden Ansprüche,
wobei sich die vertikale Ausnehmung (112) durch mehrere der Einzelschichten (101, 102) des Schichtstapels (100) hindurch erstreckt, oder wobei sich die vertikale Ausnehmung (112) durch alle Einzelschichten (101, 102) des Schichtstapels (100) hindurch erstreckt.

6. Verfahren nach einem der vorhergehenden Ansprüche,
wobei mit dem angewandten anodischen Ätzverfahren eine Vielzahl von vertikalen Kanalstrukturen (112) in einem Schichtstapel (100) mit mehr als 100 Einzelschichten (101, 102), oder mehr als 200 Einzelschichten (101, 102), oder mehr als 300 Einzelschichten (101, 102) erzeugbar ist.

7. Verfahren nach einem der vorhergehenden Ansprüche,
ferner aufweisend einen Schritt des selektiven Entfernens der Einzelschichten (101) des ersten Materials aus dem Schichtstapel (100), unter Beibehaltung der Einzelschichten (102) des zweiten Materials,
unter Anwendung eines Ätzprozesses, wobei ein Ätzmedium durch die vertikale Kanalstruktur (112) in den Schichtstapel (100) gelangt und dort die innerhalb der vertikalen Kanalstruktur (112) freigelegten und zugänglichen Einzelschichten (101, 102) des ersten und des zweiten Materials erreicht und selektiv die Einzelschichten (101) des ersten Materials aus dem Schichtstapel (100) herauslöst.

8. Verfahren nach einem der vorhergehenden Ansprüche,
wobei die Einzelschichten (101) des ersten Materials und die Einzelschichten (102) des zweiten Materials ein auf bestimmte Ätzmedien unterschiedliches Ätzverhalten aufweisen, sodass das erste Material relativ zu dem zweiten Material eine hohe Ätzselektivität aufweist.

9. Verfahren nach einem der vorhergehenden Ansprüche,
wobei die Einzelschichten (101) des ersten Materials ein erstes dotiertes Halbleitermaterial aufweisen oder aus einem ersten dotierten Halbleitermaterial bestehen, und/oder
wobei die Einzelschichten (102) des zweiten Materials ein zweites dotiertes Halbleitermaterial aufweisen oder aus einem zweiten dotierten Halbleitermaterial bestehen,
wobei das erste und das zweite dotierte Halbleitermaterial unterschiedlich sind.

10. Verfahren nach Anspruch 9,
wobei das erste dotierte Halbleitermaterial im Vergleich zu dem zweiten dotierten Halbleitermaterial einen unterschiedlichen Dotierungstyp oder einen unterschiedlichen Dotierungsgrad aufweist.

11. Verfahren nach einem der vorhergehenden Ansprüche,
wobei die Einzelschichten (101) des ersten Materials Germanium oder Siliziumgermanium aufweisen oder aus Germanium beziehungsweise Siliziumgermanium bestehen, und/oder
wobei die Einzelschichten (102) des zweiten Materials Silizium aufweisen oder aus Silizium bestehen.

12. Verfahren nach einem der vorhergehenden Ansprüche,
wobei die Einzelschichten (101) des ersten Materials und/oder die Einzelschichten (102) des zweiten Materials jeweils eine amorphe Struktur aufweisen.

13. Verfahren nach einem der vorhergehenden Ansprüche,
wobei während der Anwendung des anodischen Ätzverfahrens eine direkte Lichtquelle mit einer vorbestimmten Wellenlänge auf den Schichtstapel (100) gerichtet wird, um die Ladungsträgerdichte in dem Schichtstapel (100) zu erhöhen und dadurch den gerichteten anodischen Ätzvorgang zu unterstützen.

14. Schichtstapel (100) zur Verwendung bei der Herstellung eines dreidimensional integrierten Halbleiterspeichers (1000),
wobei der Schichtstapel (100) eine Vielzahl von vertikalen Kanalstrukturen (112) aufweist, die nach einem Verfahren gemäß einem der vorhergehenden Ansprüche hergestellt sind.

15. Dreidimensional integrierter Halbleiterspeicher (1000) mit einem Schichtstapel (100) gemäß Anspruch 14.
